(19)

Europäisches
Patentamt
European
Patent Office
Office européen
des brevets

(11) **EP 3 470 545 A1**

(12) **EUROPEAN PATENT APPLICATION**

(43) Date of publication:
**17.04.2019   Bulletin 2019/16**

(51) Int Cl.:
*C23C 14/24* (2006.01)         *C23C 14/26* (2006.01)
*F27D 5/00* (2006.01)

(21) Application number: **17195775.6**

(22) Date of filing: **10.10.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(71) Applicant: **3M Innovative Properties Company
Saint Paul, MN 55133-3427 (US)**

(72) Inventors:
• **Lesniak, Christoph
  87474 Buchenberg (DE)**

• **Uibel, Krishna
  87448 Waltenhofen (DE)**
• **Ruisinger, Bernd
  87435 Kempten (DE)**

(74) Representative: **Mössner, Brigitte
3M Deutschland GmbH
Office of Intellectual Property Counsel
(PC 072P)
Carl-Schurz-Strasse 1
41453 Neuss (DE)**

(54) **EVAPORATION BOAT FOR EVAPORATION OF METALS**

(57)     The present disclosure relates to an evaporation boat for evaporation of metals and to the use of said evaporation boat for evaporating metals selected from the group consisting of aluminum, copper and silver.

EP 3 470 545 A1

## Description

Technical Field

The present disclosure relates to an evaporation boat for evaporation of metals.

Background

The most common method for coating flexible substrates such as polymeric films or papers with metals is the so-called vacuum web coating using physical vapor depositing technology. The coated flexible substrates serve a wide field of applications such as food packaging, for decorative purposes and manufacturing of capacitors.

In vacuum web coaters, the substrate to be coated is passed over a cooled metal drum where it is exposed to metal vapor. Thus, the metal is deposited in a thin layer on the substrate.

To create the required constant metal vapor, a series of ceramic evaporation boats, aligned along the entire width of the film to be coated, are placed in cooled copper clamps and heated up by direct current flow in a vacuum of typically $10^{-4}$ mbar to temperatures of 1400 - 1550 °C. Metal wire is continuously fed to the surface of the evaporation boat where it is melted and vaporized. The most common metal used in this process is aluminum. The ceramic evaporation boat typically consists of a mixture of titanium diboride ($TiB_2$) and boron nitride (BN), sometimes aluminum nitride (AlN) is used in addition. Typically, the cross sectional area of the evaporation boat is rectangular, but cross sectional areas such as triangular, trapezoidal or elliptical are also known.

One major drawback of the process is the low energy efficiency. Only about 10 to 15% of the total electrical energy which is fed to the evaporation boat is used for vaporizing the metal. Major losses of energy stem from losses by cooling of the end areas of the boat in the copper clamps and from losses by heat radiation. Total energy costs of the vacuum web coating process equal to about 20 to 25% of the overall coating costs.

Several possibilities have been described to improve the energy efficiency of the vacuum web coating process.

DE 19708599 C1 discloses an evaporation boat having a triangular cross section. Compared to an evaporation boat with rectangular cross section, the radiating surface area is reduced.

DE 20309444 U1, DE 20300167 U1 and WO 2004063419 A1 disclose an evaporation boat having a trapezoidal cross section. Beside the reduced losses by heat radiation, a more uniform temperature distribution in the area where the metal is evaporated and less production costs are stated as main benefits.

US 6,085,025 discloses an evaporation boat with a cross section in the shape of a halved ellipse. An energy saving of 11% compared to an evaporation boat with rectangular cross section could be achieved.

Another possibility to improve energy efficiency is disclosed in US 2016/0208373 A1 and US 2016/0208374 A1 which use a thermally insulating container for the evaporation boat.

US 2016/0208373 A1 discloses an assembly consisting of a ceramic evaporation boat that is placed in a thermally insulating package made from a material comprising ceramic fibers. The evaporation boat is heated up by a pair of heaters placed at both ends of the evaporation boat. Design modifications in the clamping area are needed to fit the assembly in a typical vacuum web coater.

US 2016/0208374 A1 discloses an assembly consisting of a ceramic evaporation boat that is placed in a thermally insulating container made from a material comprising ceramic fibers. The insulating container is heated by heating elements. The evaporation boat is heated up to operating temperature through the hot insulating container. Design modifications in the clamping area are needed to fit the assembly in a typical vacuum web coater.

There is still a need to further improve evaporation boats for evaporation of metals with respect to energy efficiency during operation in the vacuum web coating process.

As used herein, "a", "an", "the", "at least one" and "one or more" are used interchangeably. Adding an "(s)" to a term means that the term should include the singular and plural form. E.g. the term "recess(es)" means one recess and more recesses (e.g. 2, 3, 4, etc.). The term "comprise" shall include also the terms "consist essentially of" and "consists of".

Summary

In a first aspect, the present disclosure relates to an evaporation boat for evaporation of metals, wherein the evaporation boat has an upper side, an underside, two lateral surfaces and two clamping surfaces, and wherein metal is evaporated from the upper side, and wherein the evaporation boat has a means for reducing losses by heat radiation under operation of the evaporation boat, and wherein the means for reducing losses by heat radiation is selected from either one of the following or a combination thereof:

(a) at least one of the lateral surfaces and/or the underside of the evaporation boat has at least one recess,

(b) at least one of the lateral surfaces and/or the underside of the evaporation boat is coated at least partially with an inorganic material.

In another aspect, the present disclosure also relates to the use of the evaporation boat disclosed herein for evaporating metals selected from the group consisting of aluminum, copper and silver.

With the evaporation boat of the present disclosure, losses by heat radiation during the web coating process are reduced. Thereby power consumption during the web coating process is reduced. In some embodiments of the present disclosure, about 15 to 40% of the total electrical energy which is fed to the evaporation boat can be saved.

The evaporation boat of the present disclosure can be used in vacuum web coaters with standard clamping devices without the need of design changes in the clamping area.

In some embodiments of the evaporation boat of the present disclosure, the temperature of the radiating surface area may be reduced compared to a standard evaporation boat. In some further embodiments, the emissivity of the radiating surface area may be reduced compared to a standard evaporation boat made from a ceramic material comprising titanium diboride and boron nitride. In some further embodiments, a combination of the temperature and the emissivity of the radiating surface area may be reduced. By reducing the temperature or the emissivity of the radiating surface area, or by reducing a combination thereof, losses by heat radiation during the web coating process are reduced.

In some embodiments of the present disclosure, the temperature distribution over the length of the evaporation boat can be modified in a targeted manner and thus specifically tailored to the application. In some embodiments, the temperature in the regions near the clamping can be increased and thus a better wetting of the metal in these regions can be achieved, resulting in higher evaporation rates. In some other embodiments, the temperature in the regions near the clamping can be decreased leading to a reduced area in which the temperature is high enough to evaporate the metal. Thus lower evaporation rates are possible with significantly lower risk of deteriorating the boat bulk material by overheating. Low evaporation rates are for example required for transparent coatings with aluminum oxide ($AlO_x$).

Brief description of the drawings

The present disclosure is explained in more detail on the basis of the drawings, in which:

Figures 1A - 1D show an evaporation boat with a rectangular cross-sectional area. According to one embodiment of the present disclosure, the two lateral surfaces and the underside of the evaporation boat shown in Figures 1A - 1D are coated with an inorganic material;

Figures 2A - 2E show a further embodiment of an evaporation boat according to the present disclosure with a rectangular cross-sectional area;

Figures 3A - 3E show a further embodiment of an evaporation boat according to the present disclosure with a rectangular cross-sectional area;

Figures 4A - 4E show a further embodiment of an evaporation boat according to the present disclosure with a rectangular cross-sectional area;

Figures 5A - 5E show a further embodiment of an evaporation boat according to the present disclosure with a rectangular cross-sectional area;

Figures 6A - 6E show a further embodiment of an evaporation boat according to the present disclosure with a rectangular cross-sectional area;

Figures 7A - 7E show a further embodiment of an evaporation boat according to the present disclosure with a rectangular cross-sectional area;

Figures 8A - 8E show a further embodiment of an evaporation boat according to the present disclosure with a rectangular cross-sectional area;

Figures 9A - 9E show a further embodiment of an evaporation boat according to the present disclosure with a rectangular cross-sectional area;

Figures 10A - 10E show a further embodiment of an evaporation boat according to the present disclosure with a rectangular cross-sectional area;

Figures 11A - 11F show a further embodiment of an evaporation boat according to the present disclosure with a rectangular cross-sectional area;

Figures 12A - 12F show a further embodiment of an evaporation boat according to the present disclosure with a rectangular cross-sectional area;

Figures 13A - 13E show an embodiment of an evaporation boat according to the present disclosure with a trapezoidal cross-sectional area;

Figures 14A - 14F show a further embodiment of an evaporation boat according to the present disclosure with a trapezoidal cross-sectional area; and

Figures 15A - 15E show a further embodiment of an evaporation boat according to the present disclosure with a rectangular cross-sectional area.

Detailed Description

Losses by heat radiation contribute significantly to the total energy losses that reduce the economy of the web coating process.

The total power radiated from an object follows the Stefan-Boltzmann law:

$$P = A\,\varepsilon\,\sigma\,T^4$$

wherein

P is the total power radiated from an object,
A is the radiating surface area of the object,
$\varepsilon$ is the emissivity of the radiating surfaces,
$\sigma$ is the Stefan-Boltzmann constant (= $5.67*10^{-8}$ $W*m^{-2}*K^{-4}$),
T is the temperature of the radiating surfaces.

The evaporation boat as disclosed herein has an upper side, an underside, two lateral surfaces and two clamping surfaces. Metal is evaporated from the upper side. The clamping surfaces, when placed into a vacuum web coater, are in contact with the copper clamps which provide current supply to the evaporation boat.

The radiating surfaces of an evaporation boat comprise the underside and the two lateral surfaces, but not the two clamping surfaces and the upper side.

The evaporation boat disclosed herein has a means for reducing losses by heat radiation under operation of the evaporation boat. The means for reducing losses by heat radiation is selected from either one of the following or a combination thereof:

(a) at least one of the lateral surfaces and/or the underside of the evaporation boat has at least one recess,
(b) at least one of the lateral surfaces and/or the underside of the evaporation boat is coated at least partially with an inorganic material.

In some embodiments of the evaporation boat according to the present disclosure, at least one of the lateral surfaces and/or the underside of the evaporation boat disclosed herein has at least one recess, and/or at least one of the lateral surfaces and/or the underside of the evaporation boat disclosed herein is coated at least partially with an inorganic material.

As used herein, a "recess" means any kind of deepening or depression, such as a bore, a cutting, a groove, a notch, a slot or a slit.

In some embodiments of the evaporation boat as disclosed herein, at least one of the lateral surfaces and/or the underside of the evaporation boat has at least one recess. With these embodiments, the temperature of the radiating surface area may be reduced compared to a standard evaporation boat without recesses. In some embodiments, one of the lateral surfaces of the evaporation boat has at least one recess. In some other embodiments, both lateral surfaces of the evaporation boat have at least one recess. In some other embodiments, the underside of the evaporation boat has at least one recess. In some other embodiments, one of the lateral surfaces and the underside of the evaporation boat have at least one recess. In some other embodiments, both lateral surfaces and the underside of the evaporation boat have at least one recess.

In some embodiments, at least one or both of the lateral surfaces of the evaporation boat have at least one recess, and the one or more recesses of the at least one or both lateral surfaces may also extend to the upper side of the evaporation boat. The recesses which extend to the upper side of the evaporation boat will not excess a distance of 3 mm from the lateral edge of the upper side of the evaporation boat.

In some embodiments of the evaporation boat disclosed herein, the underside of the evaporation boat has at least one recess, and the at least one recess of the underside is not extending to the upper side of the evaporation boat, provided that the at least one recess of the underside of the evaporation boat is not extending to the lateral surfaces. For example, the evaporation boat should not have bores at the upper side which extend to the underside of the evaporation boat. With such recesses, molten metal would flow into these recesses which should be avoided as this would locally reduce the electrical resistance of the boat, thus leading to undesired temperature variations on the upper side of the evaporation boat.

In some embodiments, the underside of the evaporation boat has at least one recess, and the one or more recesses of the underside of the evaporation boat are extending to the lateral surfaces. The one or more recesses may also extend to the upper side of the evaporation boat, and on the upper side they will not excess a distance of 3 mm from the lateral edge of the upper side of the evaporation boat.

In some embodiments, at least one of the two lateral surfaces and/or the underside of the evaporation boat has at least two, or at least three, or at least four recesses. In some embodiments, at least one of the two lateral surfaces and/or the underside of the evaporation boat has at least 5, or at least 6, or at least 7, or at least 8, or at least 9, or at least 10 recesses. In some embodiments, at least one of the two lateral surfaces and/or the underside of the evaporation boat has at least 15, or at least 20, or at least 25, or at least 30, or at least 100, or at least 300 recesses.

In some embodiments, with at least one of the two lateral surfaces and/or the underside of the evaporation boat having at least one recess, the width of the one or more recesses may be at least 0.15 mm and at most 150 mm. Specifically, the width of the one or more recesses may be at least 0.2 mm, or at least 0.5 mm, or at least 1 mm, or at least 2 mm, or at least 3 mm, or at least 5 mm, or at least 8 mm, or from 0.15 to 0.35 mm, or from 1 to 3 mm, or from 8 to 10 mm. The one or more recesses may have the form of slits.

In some embodiments, at least one of the two lateral surfaces and/or the underside of the evaporation boat has at least two recesses, and the distance between each two of the recesses may be 0.3 mm or more, and the distance between each two of the recesses may be at most the length of the evaporation boat minus 5 mm. In some embodiments, the distance between each two of the recesses may be 0.5 mm or more, or 1 mm or more, or 2 mm or more, or 3 mm or more, or 6 mm or more, or 30 mm or more, or from 3 to 5 mm, or from 6 to 8 mm, or from 30 to 50 mm. The distance between two recesses is measured from the middle of a first recess to the middle of a second recess. The one or more recesses may have the form of slits.

In some embodiments of the evaporation boat as disclosed herein, at least one of the two lateral surfaces and the underside of the evaporation boat has one or more recesses, and the one or more recesses of the at least one of the two lateral surfaces are extending to the underside of the evaporation boat. In some embodiments, both of the two lateral surfaces and the underside of the evaporation boat have one or more recesses, and the one or more recesses of both of the two lateral surfaces are extending to the underside of the evaporation boat. The one or more recesses at the at least one of the two lateral surfaces which extend to the underside of the evaporation boat may extend at most to half of the underside of the evaporation boat and may also extend to the upper side of the evaporation boat. The one or more recesses that may also extend to the upper side of the evaporation boat will not excess a distance of 3 mm from the lateral edge of the upper side of the evaporation boat.

In some embodiments, at least one or both of the two lateral surfaces and the underside of the evaporation boat has at least two, or at least three, or at least four recesses, and the recesses of the at least one or both of the two lateral surfaces are extending to the underside of the evaporation boat. In some embodiments, at least one or both of the two lateral surfaces and the underside of the evaporation boat has at least 5, or at least 6, or at least 7, or at least 8, or at least 9, or at least 10 recesses, and the recesses of the at least one or both of the two lateral surfaces are extending to the underside of the evaporation boat. In some embodiments, at least one or both of the two lateral surfaces and the underside of the evaporation boat has at least 15, or at least 20, or at least 25, or at least 30, or at least 100, or at least 300 recesses, and the recesses of the at least one or both of the two lateral surfaces are extending to the underside of the evaporation boat.

In some embodiments of the evaporation boat, with at least one of the lateral surfaces and/or the underside of the evaporation boat having at least one recess, each recess may cover a cross-sectional area of at least 5 % of the cross-sectional area of the evaporation boat. Typically, each recess may cover a cross-sectional area of at least 20%, or at least 30% of the cross-sectional area of the evaporation boat. In some embodiments, each recess may cover a cross-sectional area of at most 40%.

In some embodiments of the evaporation boat, with at least one of the lateral surfaces and/or the underside of the evaporation boat having one or more recesses, the one or more recesses have a direction parallel to the clamping surfaces and perpendicular to the lateral surfaces. In some other embodiments, the one or more recesses have a direction not parallel to the clamping surfaces and have an angle of less than 90° to one of the clamping surfaces.

In some embodiments, at least one of the lateral surfaces of the evaporation boat has a first recess in a direction along the lateral surface which is not extending to the clamping surfaces, and this first recess is directed to the underside of the evaporation boat, thereby creating a lower lateral region of the evaporation boat which is partially separated from an upper region of the evaporation boat, and the at least one of the lateral surfaces with the first recess has a second recess in a direction not parallel to the first recess, dividing the lower lateral region of the evaporation boat into two parts.

As the lower lateral region is divided into two parts, the current flow in this region is much lower than in the upper region of the evaporation boat. The second recess in a direction not parallel to the first recess is preferably in a direction perpendicular to the first recess, and the second recess is preferably located at half of the total length of the evaporation boat, thereby dividing the lower lateral region of the evaporation boat into two equal parts. The first recess in a direction along the lateral surface which is directed to the underside of the evaporation boat does not need to extend to the underside of the evaporation boat. In some embodiments, the first recess in a direction along the lateral surface which is directed to the underside of the evaporation boat may extend to the underside of the evaporation boat.

In some embodiments, the underside of the evaporation boat has a first recess in a direction along the underside which is not extending to the clamping surfaces, and this first recess is directed to one of the lateral surfaces of the evaporation boat, thereby creating a first lower region of the evaporation boat which is partially separated from an upper region of the evaporation boat. The lateral surface of the evaporation boat to which the first recess is directed to has a second recess in a direction not parallel to the first recess, dividing the first lower region of the evaporation boat into two parts. The underside of the evaporation boat optionally has a third recess in a direction along the underside which is not extending to the clamping surfaces, and this third recess is directed to the other lateral surface of the evaporation boat, thereby creating a second lower region of the evaporation boat which is partially separated from an upper region of the evaporation boat. The lateral surface of the evaporation boat to which the third recess is directed to has a fourth recess in a direction not parallel to the third recess, dividing the second lower region of the evaporation boat into two parts.

As the first and second lower lateral regions are divided into two parts, the current flow in these regions is much lower than in the upper region of the evaporation boat. The second recess in a direction not parallel to the first recess is preferably in a direction perpendicular to the first recess. The fourth recess in a direction not parallel to the third recess is preferably in a direction perpendicular to the third recess. The second recess and the fourth recess are preferably located at half of the total length of the evaporation boat, thereby dividing the first and second lower lateral regions of the evaporation boat into two equal parts. The first recess in a direction along the underside which is directed to one of the lateral surfaces of the evaporation boat does not need to extend to this lateral surface. In some embodiments, the first recess in a direction along the underside which is directed to one of the lateral surfaces of the evaporation boat may extend to this lateral surface. The third recess in a direction along the underside which is directed to the other lateral surface of the evaporation boat does not need to extend to this lateral surface. In some embodiments, the third recess in a direction along the underside which is directed to the other lateral surface of the evaporation boat may extend to this lateral surface.

In some embodiments, wherein at least one of the lateral surfaces and/or the underside of the evaporation boat have one or more recesses, from 0.1 to 65% of the total surface area of the lateral surfaces and the underside of the evaporation boat may have recesses. More specifically, from 5 to 20% of the total surface area of the lateral surfaces and the underside of the evaporation boat may have recesses.

In some embodiments, wherein at least one of the lateral surfaces and/or the underside of the evaporation boat have one or more recesses, from 0.1 to 75% of the total volume of the evaporation boat may have recesses. More specifically, from 0.2 to 1%, or from 1 to 2%, or from 2 to 4%, or from 4 to 6%, or from 6 to 10%, or from 10 to 15%, or from 15 to 20%, or from 20 to 30%, or from 30 to 40%, or from 40 to 50%, or from 50 to 60%, or from 60 to 70% of the total volume of the evaporation boat may have recesses.

The evaporation boat as disclosed herein may have a rectangular, triangular or trapezoidal cross-sectional area. The evaporation boat as disclosed herein may also have a cross sectional area shaped as segment of an ellipse or circle.

The evaporation boat as disclosed herein is heated up by direct current flow. For the embodiments of the present disclosure wherein at least one of the lateral surfaces and/or the underside of the evaporation boat has one or more recesses, the evaporation boat has a region with a higher current flow and a region with a lower current flow. These two different regions are a result of the recesses. The cross-sectional area of the region with the higher current flow is smaller than the cross-sectional area of the evaporation boat. The cross-sectional area of the region with the higher current flow may be rectangular, triangular, trapezoidal, or shaped in T-form or as segment of an ellipse or circle.

In some embodiments of the evaporation boat disclosed herein, the temperature distribution over the length of the evaporation boat can be modified in a targeted manner and thus specifically tailored to the application. In some embodiments, the temperature on the upper side of the evaporation boat in the regions near the clamping can be increased and thus a better wetting of the metal in these regions can be achieved, resulting in a better wetting on the surface area of the upper side and in higher evaporation rates. High evaporation rates are for example required for food packaging where polymer films are coated with a thin layer of aluminum, providing barrier properties against oxygen and moisture. These coatings with a thin layer of aluminum are non-transparent.

In some further embodiments of the evaporation boat disclosed herein, the temperature on the upper side of the evaporation boat in the regions near the clamping can be decreased. With these embodiments, lower evaporation rates are possible. Lower evaporation rates are for example required for transparent coatings with aluminum oxide ($AlO_x$). Transparent coatings with aluminum oxide ($AlO_x$) having also the required barrier properties can be produced in typical web coaters using ceramic evaporation boats. This is done my means of injecting oxygen gas into the cloud of aluminum vapour obove the evaporation boat, thus forming in-situ $AlO_x$ species which are deposited on the cooled film. To produce these transparent $AlO_x$ coatings, film speed and thus the amount of aluminum fed to the evaporation boat are much lower than for coatings with a thin film of aluminum. When using standard evaporation boats for transparent $AlO_x$ coatings with low evaporation rates, there will be regions on the upper side of the boat which are not wetted by liquid aluminum. In these regions the temperature will be very high, and therefore there is a great risk of deterioration of the boat bulk material resulting in a shorter service life of the evaporation boat. By using evaporation boats according to some embodiments of the present disclosure, the temperature in the regions near the clamping can be decreased, leading to a reduced area in which the temperature is high enough to evaporate metal. Thus lower evaporation rates are possible with significant less risk of deteriorating the boat bulk material by overheating.

The material from which the evaporation boat disclosed herein is made comprises titanium diboride and boron nitride. In some embodiments, the material from which the evaporation boat is made comprises also aluminum nitride. The titanium diboride content of the material from which the evaporation boat is made typically ranges from 30 to 40 vol.-%.

The volume of the evaporation boat disclosed herein typically ranges from about 25 cm$^3$ to 75 cm$^3$.

The evaporation boats disclosed herein can be produced by conventional methods such as hot-pressing a powder mixture comprising titanium diboride and boron nitride into a hot-pressed body and machining the evaporation boats from the hot-pressed bodies. The recesses can be produced by machining, such as grinding, wire sawing or water jet cutting.

In some embodiments of the present disclosure, at least one of the lateral surfaces and/or the underside of the evaporation boat is coated at least partially with an inorganic material. With these embodiments, the emissivity of the radiating surface area may be reduced compared to a standard evaporation boat made from a ceramic material comprising titanium diboride and boron nitride. The cross-sectional area of the evaporation boat may be rectangular, triangular, trapezoidal, or shaped in T-form or as segment of an ellipse or circle. The lateral surfaces and the underside of the evaporation boat of this embodiment may not be provided with recesses.

In some further embodiments of the present disclosure, at least one of the lateral surfaces and/or the underside of the evaporation boat has at least one recess, and at least one of the lateral surfaces and/or the underside of the evaporation boat is coated at least partially with an inorganic material. With these embodiments, the temperature and the emissivity of the radiating surface area may be reduced compared to an evaporation boat without recesses and without a coating with an inorganic material.

In some further embodiments of the present disclosure, at least one of the lateral surfaces and/or the underside of the evaporation boat has at least one recess, and the at least one recess of the evaporation boat is coated or filled at least partially with an inorganic material. With these embodiments, the temperature and the emissivity of the radiating surface area may be reduced compared to an evaporation boat without recesses.

In some other embodiments, at least one of the lateral surfaces and/or the underside of the evaporation boat has at least one recess, and the at least one recess of the evaporation boat is coated or filled at least partially with an inorganic material, and at least one of the lateral surfaces and/or the underside of the evaporation boat is coated at least partially with an inorganic material. With these embodiments, the size and the temperature and the emissivity of the radiating surface area may be reduced compared to an evaporation boat without recesses and without a coating with an inorganic material.

The inorganic material may comprise oxides such as alumina, magnesia, zirconia, titanium dioxide or mixed oxides, or their precursors from a sol-gel process, hydroxides such as aluminum hydroxide, borides such as titanium diboride, tungsten borides and molybdenum boride, carbides, nitrides such as boron nitride, aluminum nitride and titanium nitride, minerals, metals, high melting glasses or combinations thereof. Examples for minerals are silicates such as aluminosilicates (e.g. kyanite or mullite), magnesium silicate (e.g. enstatite, cordierite, celsian), or zirconium silicates (e.g. zircon), and other minerals containing barium or calcium. Examples for metals are titanium, tungsten and molybdenum. The inorganic material may be applied as slurry, paste or granules by customary methods such as painting, brushing and spraying. Fibers of woven fabric can enhance the mechanical stability of the coating, e.g. alumina fibers like 3M™ Nextel™ fibers.

The coating with the inorganic material serves for reducing the emissivity of the radiating surfaces, thereby reducing losses by heat radiation. The coating with the inorganic material may also serve for thermal insulation.

Typically, the coating with the inorganic material has a thickness of 2 to 2000 $\mu$m. More specifically, the thickness may be from 5 to 100 µm or more for reduced radiation. For a coating serving as thermal insulation coating, thicknesses up to 2000 µm or more can be applied.

The upper side of the evaporation boat may have a cavity for the molten metal. The upper side of the evaporation boat may also have a coating or a structuring to improve the wettability by the molten metal. The structuring may be obtained by mechanical machining or by treatment with a high-energy beam.

Various embodiments of the evaporation boat according to the present disclosure are shown in the drawings.

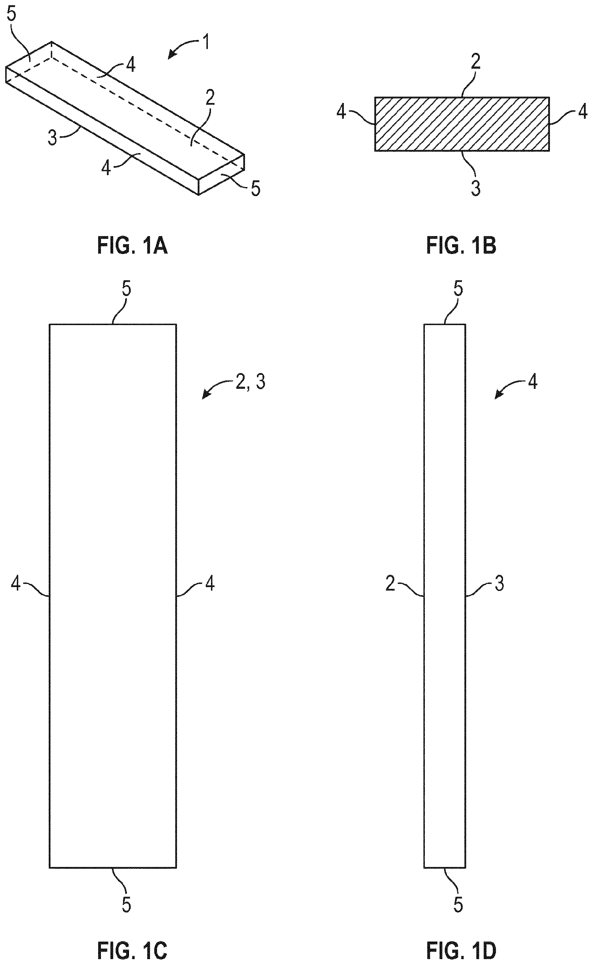

In Figures 1A - 1D, an evaporation boat 1 with a rectangular cross-sectional area is shown. Dimensions may be 10 x 30 x 130 mm, for example. Figure 1A is a 3D view, Figure 1B is a cross sectional view of the evaporation boat, Figure 1C is a plan view of the upper side 2 and of the underside 3, Figure 1D is a plan view of one of the lateral surfaces 4. As can be seen in Figures 1A - 1D, the evaporation boat has an upper side 2, an underside 3, two lateral surfaces 4 and two clamping surfaces 5. Metal is evaporated from the upper side 2 of the evaporation boat. Typically, aluminum is evaporated from the upper side 2 of the evaporation boat. The evaporation boat is heated by direct current flow. According to some embodiments of the present disclosure, the two lateral surfaces 4 and the underside 3 of the evaporation boat shown in Figures 1A - 1D are coated with an inorganic material. With these embodiments, the emissivity of the radiating surface area may be reduced compared to a standard evaporation boat made from a ceramic material comprising titanium diboride and boron nitride.

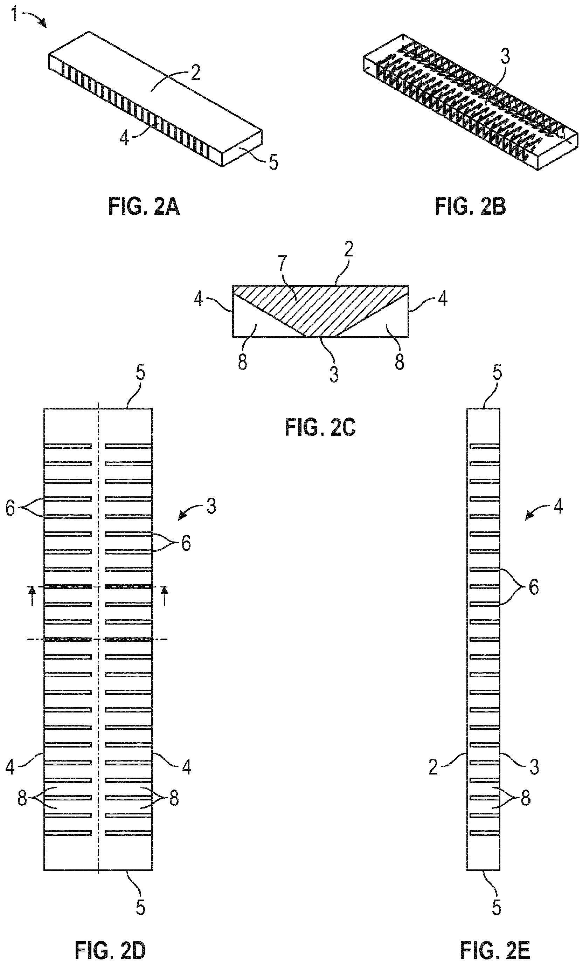

Figures 2A - 2E show a further embodiment of an evaporation 1 boat according to the present disclosure with a rectangular cross-sectional area. Dimensions may be 10 x 30 x 130 mm, for example. Figure 2A is a 3D view of the upper side 2, Figure 2B is a 3D view of the underside 3. Both lateral surfaces 4 of the evaporation boat have 23 slits 6. The 23 slits 6 have a direction parallel to the clamping surfaces 5 and perpendicular to the lateral surfaces 4. Figure 2D is a plan view of the underside 3, Figure 2E is a plan view of one of the lateral surfaces 4. The other lateral surface is identical to Figure 2E. Figure 2C is a cross sectional view of the evaporation boat at the position of one of the slits 6 which is indicated in Figure 2D by arrows. The cross-sectional area at this position has a trapezoidal shape, whereas the cross-sectional area at the positions between the slits and in the clamping area near the clamping surfaces 5 is rectangular (see Figure 2C). The 23 slits 6 are extending from the lateral surface 4 to the underside 3 of the evaporation boat. As can be seen from Figure 2D representing a plan view of the underside 3, the slits of both lateral surfaces 4 are extending to almost half of the underside 3. As can be seen from Figure 2E representing a plan view of a lateral surface 4, the slits 6 at the lateral surface 4 are not extending to the upper side 2 of the evaporation boat. There are no slits at the upper side 2 of the evaporation boat (see Figure 2A), the plan view of the upper side 2 corresponds to Figure 1C. The width of the slits 6 is 1 mm. The distance between each two of the slits is 5 mm. At a region having a length of 10 mm at both ends of the evaporation boat, there may be no slits, as these two regions are the clamping regions of the evaporation boat. By the slits of the evaporation boat of this embodiment, heat losses at both lateral surfaces and at the underside of the evaporation boat are reduced compared to an evaporation boat with a rectangular cross-sectional area and without recesses. With this embodiment, the temperature of the radiating surface area can be reduced compared to an evaporation boat with a rectangular cross-sectional area and without recesses. The core region 7 of the evaporation boat (see Figure 2C), which is composed of the regions having a trapezoidal cross-sectional area at the positions of the 23 slits and the regions with this trapezoidal cross-sectional area between the positions of the 23 slits, has a higher current flow than the regions between the 23 slits having a triangular cross-sectional area 8. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

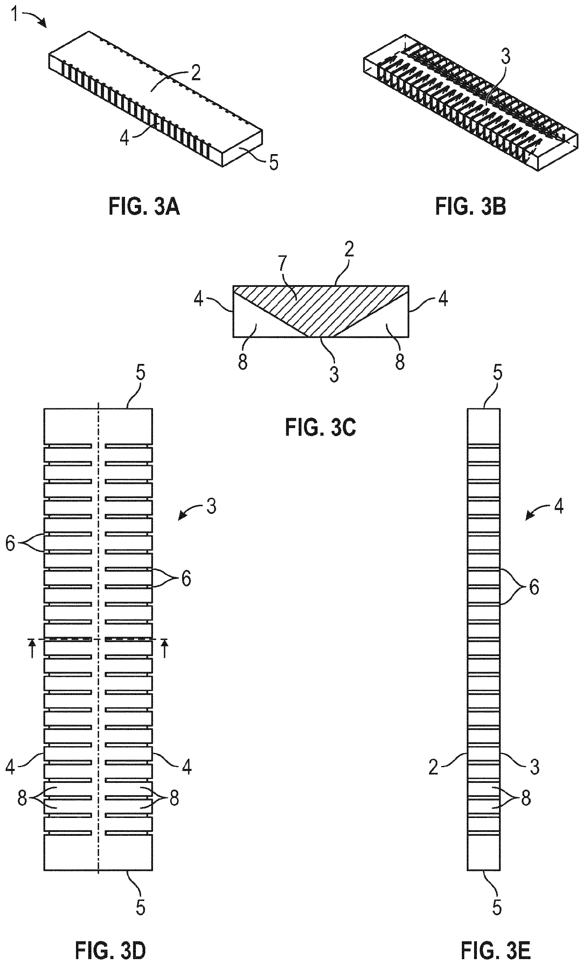

Figures 3A - 3E show yet a further embodiment of an evaporation 1 boat according to the present disclosure with a rectangular cross-sectional area. Dimensions may be 10 x 30 x 130 mm, for example. Figure 3A is a 3D view of the upper side, Figure 3B is a 3D view of the underside. Both lateral surfaces of the evaporation boat have 23 slits 6. The 23 slits 6 have a direction parallel to the clamping surfaces 5 and perpendicular to the lateral surfaces 4. Figure 3D is a plan view of the underside 3, Figure 3E is a plan view of one of the lateral surfaces 4. The other lateral surface is identical to Figure 3E. Figure 3C is a cross sectional view of the evaporation boat at the position of one of the slits 6 which is indicated in Figure 3D by arrows. The cross section at this position has a trapezoidal shape, whereas the cross section at the positions between the slits and in the clamping area near the clamping surfaces 5 is rectangular (see Figure 3C). The 23 slits 6 are extending from the lateral surface 4 to the underside 3 of the evaporation boat. As can be seen from Figure 3D representing a plan view of the underside, the slits 6 of both lateral surfaces are extending to almost half of the underside. As can be seen from Figure 3E representing a plan view of a lateral surface 4, the slits 6 at the lateral surface 4 are extending to the upper side 2 of the evaporation boat 1. At the upper side 2, the slits 6 are extending to a kind of lateral stripe on the upper side, the lateral stripe having a breadth of 1 mm. The width of the slits 6 is 1 mm. The distance between each two of the slits 6 is 5 mm. At a region having a length of 10 mm at both ends of the evaporation boat, there may be no slits, as these two regions are the clamping regions of the evaporation boat. By the slits of the evaporation boat of this embodiment, heat losses at both lateral surfaces and at the underside of the evaporation boat are reduced compared to an evaporation boat with a rectangular cross-sectional area and without slits or recesses. With this embodiment, the temperature of the radiating surface area can be reduced compared to a standard evaporation boat with a rectangular cross-sectional area and without recesses. The core region 7 of the evaporation boat (see Figure 3C), which is composed of the regions having a trapezoidal cross-sectional area at the positions of the 23 slits and the regions with this trapezoidal cross-sectional area between the positions of the 23 slits, has a higher current flow than the regions between the 23 slits having a triangular cross-sectional area 8. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

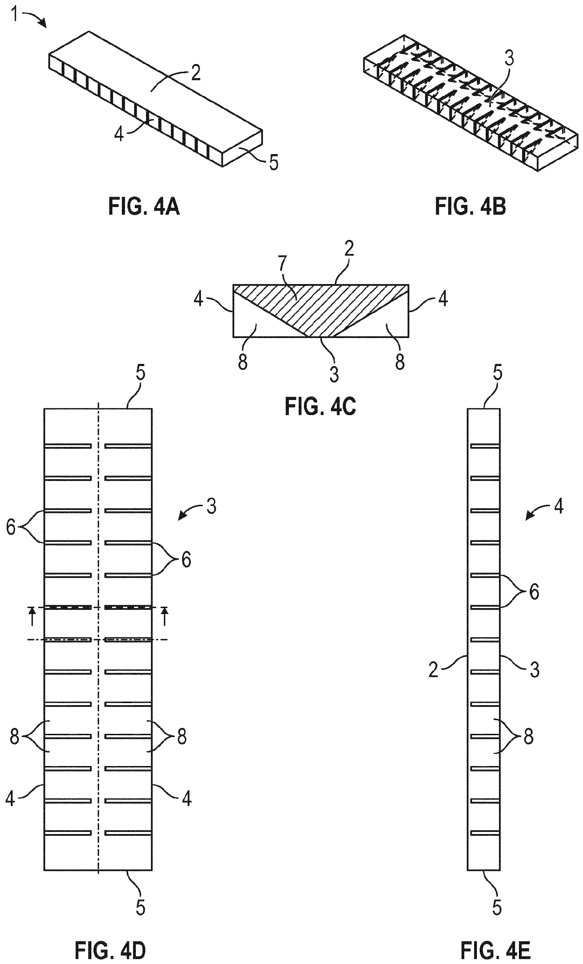

Figures 4A - 4E show yet a further embodiment of an evaporation boat 1 according to the present disclosure with a rectangular cross-sectional area. Dimensions may be 10 x 30 x 130 mm, for example. Figure 4A is a 3D view of the upper side 2, Figure 4B is a 3D view of the underside 3. Both lateral surfaces 4 of the evaporation boat have 13 slits 6. The 13 slits 6 have a direction parallel to the clamping surfaces 5 and perpendicular to the lateral surfaces 4. Figure 4D is a plan view of the underside, Figure 4E is a plan view of one of the lateral surfaces 4. The other lateral surface is identical to Figure 4E. Figure 4C is a cross sectional view of the evaporation boat at the position of one of the slits 6 which is indicated in Figure 4D by arrows. The cross section at this position has a trapezoidal shape, whereas the cross section at the positions between the slits and in the clamping area near the clamping surfaces 5 is rectangular (see Figure 4C). The 13 slits 6 are extending from the lateral surface 4 to the underside 3 of the evaporation boat. As can be seen from Figure 4D representing a plan view of the underside, the slits 6 of both lateral surfaces are extending to almost half of the underside 3. As can be seen from Figure 4E representing a plan view of a lateral surface, the slits 6 at the lateral surface 4 are not extending to the upper side 2 of the evaporation boat. There are no slits at the upper side of the evaporation boat (see Figure 4A), the plan view of the upper side corresponds to Figure 1C. The width of the slits 6 is 1 mm. The distance between each two of the slits 6 is 9 mm. At a region having a length of 10 mm at both ends of the evaporation boat, there may be no slits, as these two regions are the clamping regions of the evaporation boat. By the slits of the evaporation boat of this embodiment, heat losses at both lateral surfaces and at the underside of the evaporation boat are reduced compared to an evaporation boat with a rectangular cross-sectional area and without slits. With this embodiment, the temperature of the radiating surface area can be reduced compared to a standard evaporation boat with a rectangular cross-sectional area and without recesses. The core region 7 of the evaporation boat (see Figure 4C), which is composed of the regions having a trapezoidal cross-sectional area at the positions of the 13 slits and the regions with this trapezoidal cross-sectional area between the positions of the 13 slits, has a higher current flow than the regions between the 13 slits having a triangular cross-sectional area 8. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

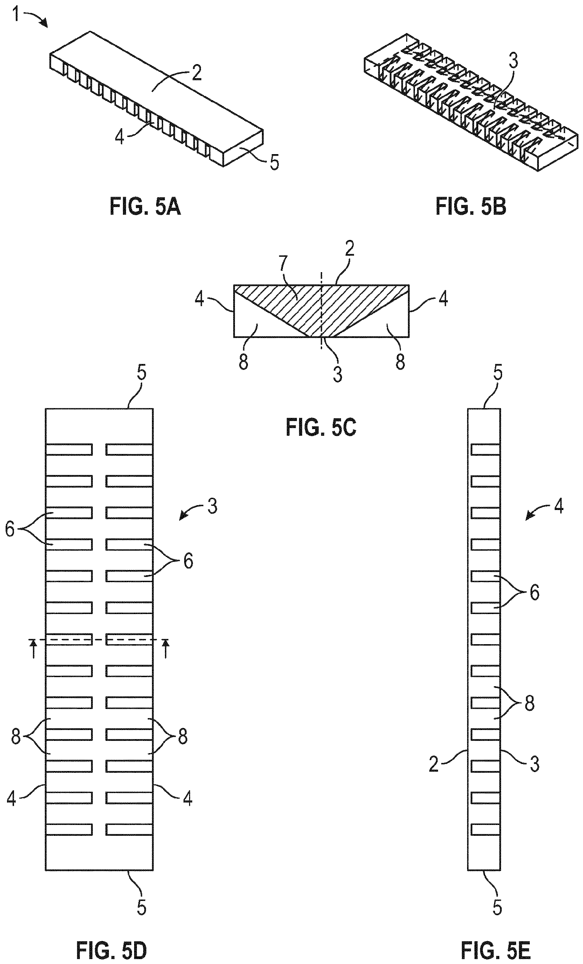

Figures 5A - 5E show yet a further embodiment of an evaporation boat 1 according to the present disclosure with a rectangular cross-sectional area. Dimensions may be 10 x 30 x 130 mm, for example. Figure 5A is a 3D view of the upper side 2, Figure 5B is a 3D view of the underside 3. Both lateral surfaces 4 of the evaporation boat have 13 slits 6. The 13 slits 6 have a direction parallel to the clamping surfaces 5 and perpendicular to the lateral surfaces 4. Figure 5D is a plan view of the underside 3, Figure 5E is a plan view of one of the lateral surfaces 4. The other lateral surface is identical to Figure 5E. Figure 5C is a cross sectional view of the evaporation boat at the position of one of the slits 6 which is indicated in Figure 5D by arrows. The cross-sectional area at this position has a trapezoidal shape, whereas the cross-sectional area at the positions between the slits 6 and in the clamping area near the clamping surfaces 5 is rectangular (see Figure 5C). The 13 slits 6 are extending from the lateral surface 4 to the underside 3 of the evaporation boat. As can be seen from Figure 5D representing a plan view of the underside, the slits 6 of both lateral surfaces 4 are extending to almost half of the underside 3. As can be seen from Figure 5E representing a plan view of a lateral surface 4, the slits 6 at the lateral surface 4 are not extending to the upper side 2 of the evaporation boat 1. There are no slits at the upper side of the evaporation boat (see Figure 5A), the plan view of the upper side 2 corresponds to Figure 1C. The width of the slits is 3 mm. The distance between each two of the slits is 9 mm. At a region having a length of 10 mm at both ends of the evaporation boat, there may be no slits, as these two regions are the clamping regions of the evaporation boat. By the slits of the evaporation boat of this embodiment, heat losses at both lateral surfaces and at the underside of the evaporation boat are reduced compared to an evaporation boat with a rectangular cross-sectional area and without slits. With this embodiment, the temperature of the radiating surface area can be reduced compared to a standard evaporation boat with a rectangular cross-sectional area and without recesses. The core region 7 of the evaporation boat (see Figure 5C), which is composed of the regions having a trapezoidal cross-sectional area at the positions of the 13 slits and the regions with this trapezoidal cross-sectional area between the positions of the 13 slits, has a higher current flow than the regions between the 13 slits having a triangular cross-sectional area 8. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

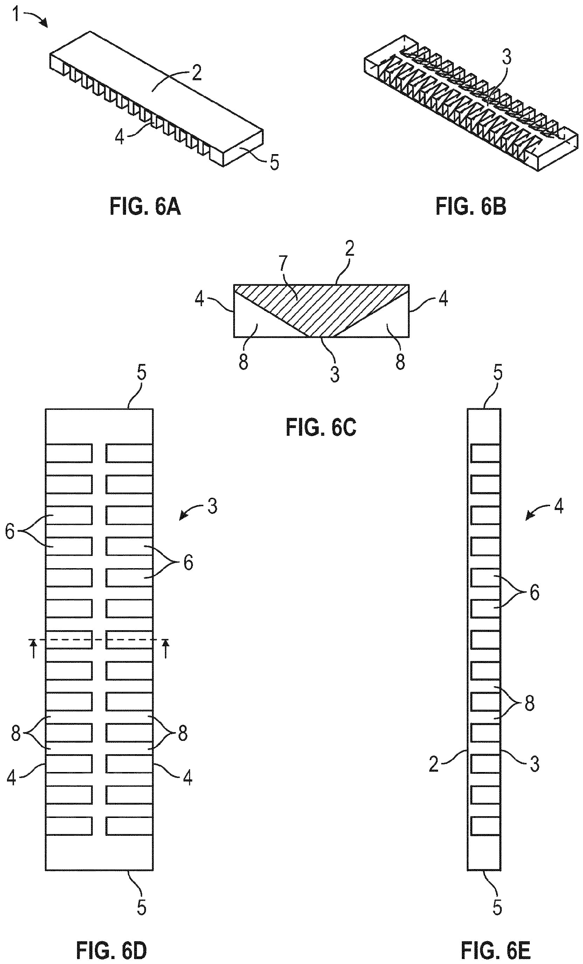

Figures 6A - 6E show yet a further embodiment of an evaporation boat 1 according to the present disclosure with a rectangular cross-sectional area. Dimensions may be 10 x 30 x 130 mm, for example. Figure 6A is a 3D view of the upper side 2, Figure 6B is a 3D view of the underside 3. Both lateral surfaces 4 of the evaporation boat have 13 slits 6. The 13 slits 6 have a direction parallel to the clamping surfaces 5 and perpendicular to the lateral surfaces 4. Figure 6D is a plan view of the underside 3, Figure 6E is a plan view of one of the lateral surfaces 4. The other lateral surface is identical to Figure 6E. Figure 6C is a cross sectional view of the evaporation boat at the position of one of the slits 6 which is indicated in Figure 6D by arrows. The cross-sectional area at this position has a trapezoidal shape, whereas the cross-sectional area at the positions between the slits 6 and in the clamping area near the clamping surfaces 5 is rectangular (see Figure 6C). The 13 slits 6 are extending from the lateral surface to the underside of the evaporation boat.

As can be seen from Figure 6D representing a plan view of the underside 3, the slits 6 of both lateral surfaces 4 are extending to almost half of the underside 3. As can be seen from Figure 6E representing a plan view of a lateral surface 4, the slits 6 at the lateral surface are not extending to the upper side 2 of the evaporation boat. There are no slits at the upper side 2 of the evaporation boat (see Figure 6A), the plan view of the upper side corresponds to Figure 1C. The width of the slits is 5 mm. The distance between each two of the slits is 9 mm. At a region having a length of 10 mm at both ends of the evaporation boat, there may be no slits, as these two regions are the clamping regions of the evaporation boat. By the slits of the evaporation boat of this embodiment, heat losses at both lateral surfaces and at the underside of the evaporation boat are reduced compared to an evaporation boat with a rectangular cross-sectional area and without slits. With this embodiment, the temperature of the radiating surface area can be reduced compared to a standard evaporation boat with a rectangular cross-sectional area and without recesses. The core region 7 of the evaporation boat (see Figure 6C), which is composed of the regions having a trapezoidal cross-sectional area at the positions of the 13 slits and the regions with this trapezoidal cross-sectional area between the positions of the 13 slits, has a higher current flow than the regions between the 13 slits having a triangular cross-sectional area 8. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

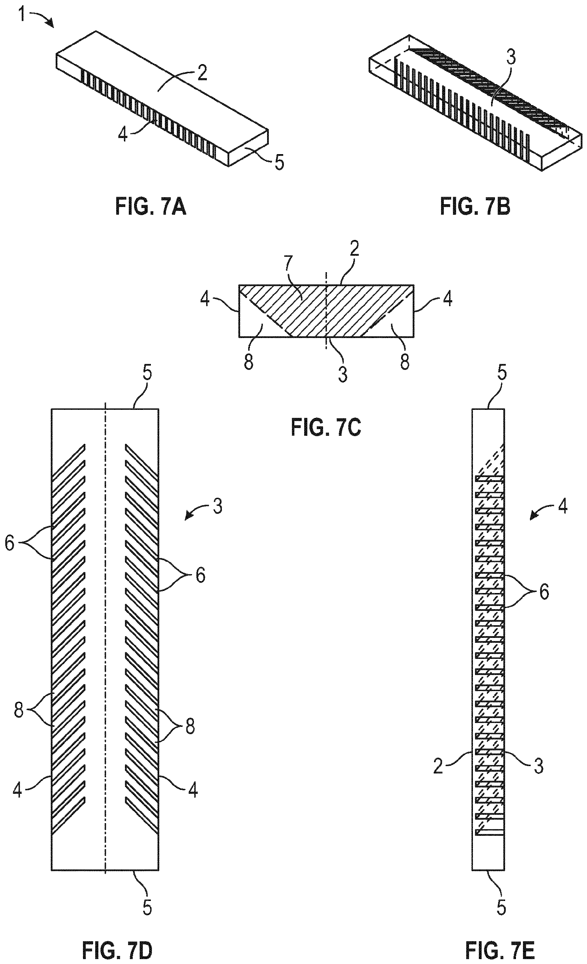

Figures 7A - 7E show yet a further embodiment of an evaporation boat 1 according to the present disclosure with a rectangular cross-sectional area. Dimensions may be 10 x 30 x 130 mm, for example. Figure 7A is a 3D view of the upper side 2, Figure 7B is a 3D view of the underside 3. Both lateral surfaces 4 of the evaporation boat have 23 slits 6. The 23 slits 6 have a direction not parallel to the clamping surfaces 5 and have an angle of 45° to one of the clamping surfaces 5. Figure 7D is a plan view of the underside 3, Figure 7E is a plan view of one of the lateral surfaces 4. The other lateral surface is identical to Figure 7E. Figure 7C is a plan view of the evaporation boat at one of the clamping surfaces 5. As can be seen from Figure 7C, the evaporation boat has a core region 7 with a trapezoidal shape, which is not interrupted by slits or recesses. The 23 slits 6 are extending from the lateral surface 4 to the underside 3 of the evaporation boat. As can be seen from Figure 7D representing a plan view of the underside, the slits 6 of both lateral surfaces are extending to about a third of the underside 3. As can be seen from Figure 7E representing a plan view of a lateral surface, the slits 6 at the lateral side 4 are not extending to the upper side 2 of the evaporation boat 1. There are no slits 6 at the upper side of the evaporation boat (see Figure 7A), the plan view of the upper side corresponds to Figure 1C. The width of the slits is 1 mm. The distance between each two of the slits is 3 mm. At a region having a length of 10 mm at both ends of the evaporation boat, there may be no slits, as these two regions are the clamping regions of the evaporation boat. By the slits of the evaporation boat of this embodiment, heat losses at both lateral surfaces and at the underside of the evaporation boat are reduced compared to an evaporation boat with a rectangular cross-sectional area and without slits. With this embodiment, the temperature of the radiating surface area can be reduced compared to a standard evaporation boat with a rectangular cross-sectional area and without recesses. The core region 7 of the evaporation boat has a higher current flow than the regions 8 between the 23 slits 6 which have a triangular form in the plan view of Figure 7C. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

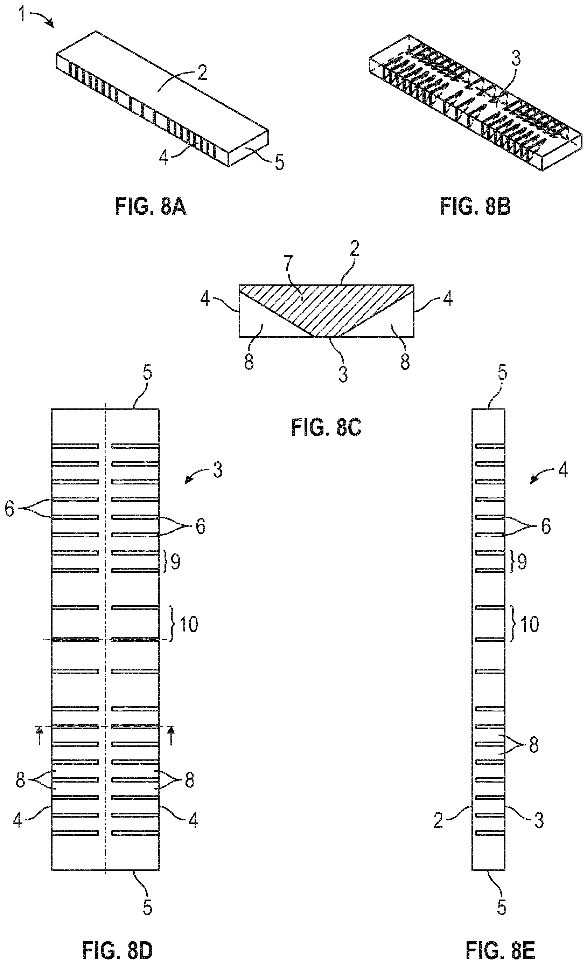

Figures 8A - 8E show yet a further embodiment of an evaporation boat 1 according to the present disclosure with a rectangular cross-sectional area. Dimensions may be 10 x 30 x 130 mm, for example. Figure 8A is a 3D view of the upper side 2, Figure 8B is a 3D view of the underside 3. Both lateral surfaces 4 of the evaporation boat have 19 slits 6. The 19 slits 6 have a direction parallel to the clamping surfaces 5 and perpendicular to the lateral surfaces 4. Figure 8D is a plan view of the underside 3, Figure 8E is a plan view of one of the lateral surfaces 4. The other lateral surface is identical to Figure 8E. Figure 8C is a cross sectional view of the evaporation boat at the position of one of the slits 6 which is indicated in Figure 8D by arrows. The cross-sectional area at this position has a trapezoidal shape, whereas the cross-sectional area at the positions between the slits and in the clamping area near the clamping surfaces is rectangular (see Figure 8C). The 19 slits 6 are extending from the lateral surface 4 to the underside 3 of the evaporation boat. As can be seen from Figure 8D representing a plan view of the underside 3, the slits of both lateral surfaces are extending to almost half of the underside. As can be seen from Figure 8E representing a plan view of a lateral surface 4, the slits at the lateral surface are not extending to the upper side 2 of the evaporation boat. There are no slits at the upper side 2 of the evaporation boat (see Figure 8A), the plan view of the upper side corresponds to Figure 1C. The width of the slits is 1 mm. In the two regions near the clamping, covering the first and the last third of the total length of the evaporation boat, the distance 9 of each two of the slits is 5 mm and smaller than the distance 10 between each two of the three slits in the middle region of the evaporation boat which is 9 mm. The distance between the first and last of the three slits in the middle region and the adjacent slit is 10 mm. At a region having a length of 10 mm at both ends of the evaporation boat, there may be no slits, as these two regions are the clamping regions of the evaporation boat. By the slits of the evaporation boat of this embodiment, heat losses at both lateral surfaces and at the underside of the evaporation boat are reduced compared to an evaporation boat with a rectangular cross-sectional area and without slits. With this embodiment, the temperature of the radiating surface area can be reduced compared to a standard evaporation boat without recesses. The temperature at the lateral surfaces and at the underside is reduced under operation of the evaporation boat, compared to a standard evaporation boat with a rectangular cross-sectional area and without slits. In the two regions near the clamping having slits with a distance of 5 mm, the temperature on the upper side of the evaporation boat can be increased compared to an evaporation boat without recesses. Thus a better wetting of the aluminum in these regions can be achieved, resulting in a better wetting on the surface area of the upper side and in higher evaporation rates. The core region 7 of the evaporation boat (see Figure 8C), which is composed of the regions having a trapezoidal cross-sectional area at the positions of the 19 slits and the regions with this trapezoidal cross-sectional area between the positions of the 19 slits, has a higher current flow than the regions between the 19 slits having a triangular cross-sectional area 8. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

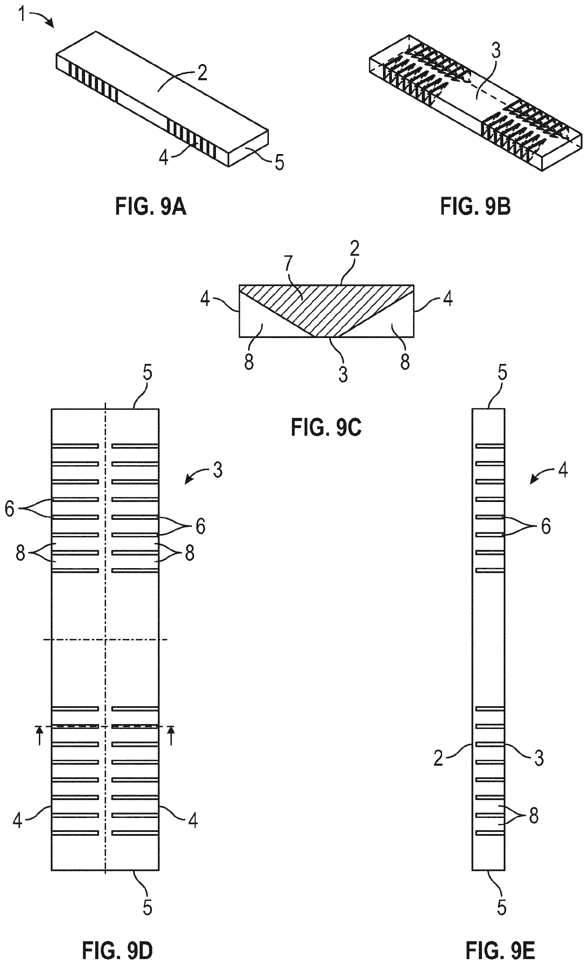

Figures 9A - 9E show yet a further embodiment of an evaporation boat 1 according to the present disclosure with a rectangular cross-sectional area. Dimensions may be 10 x 30 x 130 mm, for example. Figure 9A is a 3D view of the upper side 2, Figure 9B is a 3D view of the underside 3. Both lateral surfaces 4 of the evaporation boat have 16 slits 6. The 16 slits 6 have a direction parallel to the clamping surfaces 5 and perpendicular to the lateral surfaces 4. Figure 9D is a plan view of the underside 3, Figure 9E is a plan view of one of the lateral surfaces 4. The other lateral surface is identical to Figure 9E. Figure 9C is a cross sectional view of the evaporation boat at the position of one of the slits 6 which is indicated in Figure 9D by arrows. The cross section at this position has a trapezoidal shape, whereas the cross section at the positions between the slits and in the clamping area near the clamping surfaces 5 is rectangular (see Figure 9C). The 16 slits are extending from the lateral surface 4 to the underside 3 of the evaporation boat. As can be seen from Figure 9D representing a plan view of the underside 3, the slits of both lateral surfaces are extending to almost half of the underside. As can be seen from Figure 9E representing a plan view of a lateral surface 4, the slits at the lateral surface are not extending to the upper side 2 of the evaporation boat. There are no slits at the upper side of the evaporation boat (see Figure 9A), the plan view of the upper side 2 corresponds to Figure 1C. The width of the slits is 1 mm. In the two regions near the clamping, covering the first and the last third of the total length of the evaporation boat, the distance of each two of the slits is 5 mm. In the middle region of the evaporation boat, there are no slits. At a region having a length of 10 mm at both ends of the evaporation boat, there may be no slits, as these two regions are the clamping regions of the evaporation boat. By the slits of the evaporation boat of this embodiment, heat losses at both lateral surfaces and at the underside of the evaporation boat are reduced compared to an evaporation boat with a rectangular cross-sectional area and without slits. With this embodiment, the temperature of the radiating surface area can be reduced compared to a standard evaporation boat with a rectangular cross-sectional area and without recesses. The temperature at the lateral surfaces and at the underside is reduced under operation of the evaporation boat, compared to a standard evaporation boat with a rectangular cross-sectional area and without slits. In the two regions near the clamping, covering the first and the last third of the total length of the evaporation boat and having slits with a distance of 5 mm, the temperature on the upper side of the evaporation boat can be increased compared to an evaporation boat without recesses. Thus a better wetting of the aluminum in these regions can be achieved, resulting in a better wetting on the surface area of the upper side and in higher evaporation rates. The core region 7 of the evaporation boat (see Figure 9C), which is composed of the regions having a trapezoidal cross-sectional area at the positions of the 16 slits and the regions with this trapezoidal cross-sectional area between the positions of the 16 slits, has a higher current flow than the regions between the 16 slits having a triangular cross-sectional area 8. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

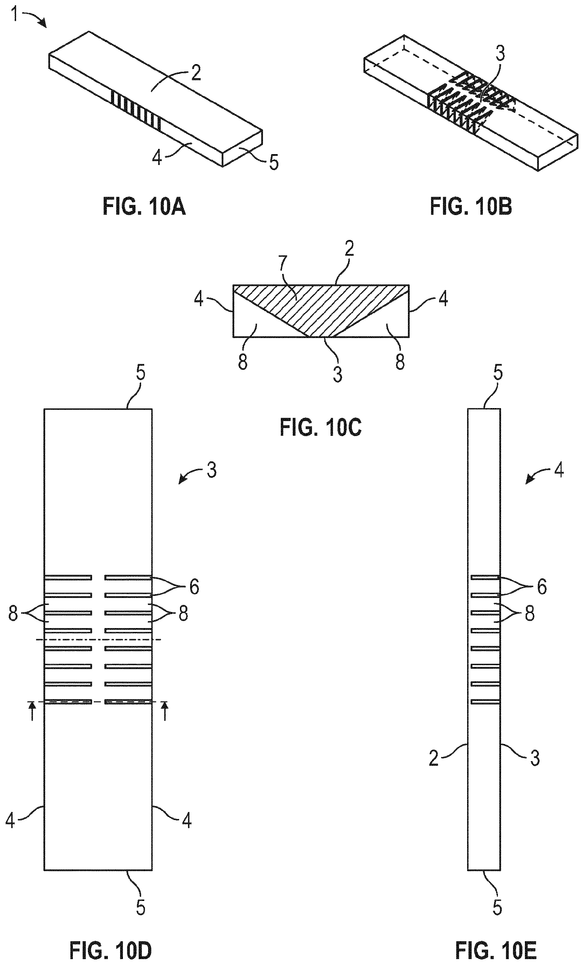

Figures 10A - 10E show yet a further embodiment of an evaporation boat 1 according to the present disclosure with a rectangular cross-sectional area. Dimensions may be 10 x 30 x 130 mm, for example. Figure 10A is a 3D view of the upper side 2, Figure 10B is a 3D view of the underside 3. Both lateral surfaces 4 of the evaporation boat have 8 slits 6.

The 8 slits 6 have a direction parallel to the clamping surfaces 5 and perpendicular to the lateral surfaces 4. Figure 10D is a plan view of the underside 3, Figure 10E is a plan view of one of the lateral surfaces 4. The other lateral surface is identical to Figure 10E. Figure 10C is a cross sectional view of the evaporation boat at the position of one of the slits 6 which is indicated in Figure 10D by arrows. The cross section at this position has a trapezoidal shape, whereas the cross section at the positions between the slits and in the clamping area near the clamping surfaces 5 is rectangular (see Figure 10C). The 8 slits are extending from the lateral surface 4 to the underside 3 of the evaporation boat. As can be seen from Figure 10D representing a plan view of the underside 3, the slits of both lateral surfaces are extending to almost half of the underside. As can be seen from Figure 10E representing a plan view of a lateral surface 4, the slits at the lateral surface are not extending to the upper side 2 of the evaporation boat. There are no slits at the upper side of the evaporation boat (see Figure 10A), the plan view of the upper side 2 corresponds to Figure 1C. The width of the slits is 1 mm. In the two regions near the clamping, covering the first and the last third of the total length of the evaporation boat, there are no slits or recesses. In the middle region of the evaporation boat, there are 8 slits 6, the distance of each two of the slits being 5 mm. By the slits of the evaporation boat of this embodiment, heat losses at both lateral surfaces and at the underside of the evaporation boat are reduced compared to an evaporation boat with a rectangular cross-sectional area and without slits. With this embodiment, the temperature of the radiating surface area can be reduced compared to a standard evaporation boat with a rectangular cross-sectional area and without recesses. The temperature at the lateral surfaces and at the underside is reduced under operation of the evaporation boat, compared to a standard evaporation boat with a rectangular cross-sectional area and without slits. In the two regions near the clamping, covering the first and the last third of the total length of the evaporation boat and having no slits, the temperature on the upper side of the evaporation boat can be decreased. Therefore the area in which the temperature is high enough to evaporate metal is reduced, and thus lower evaporation rates are possible with significant less risk of deteriorating the boat bulk material by overheating. The core region 7 of the evaporation boat (see Figure 10C), which is composed of the regions having a trapezoidal cross-sectional area at the positions of the 8 slits and the regions with this trapezoidal cross-sectional area between the positions of the 8 slits, has a higher current flow than the regions between the 8 slits having a triangular cross-sectional area 8. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

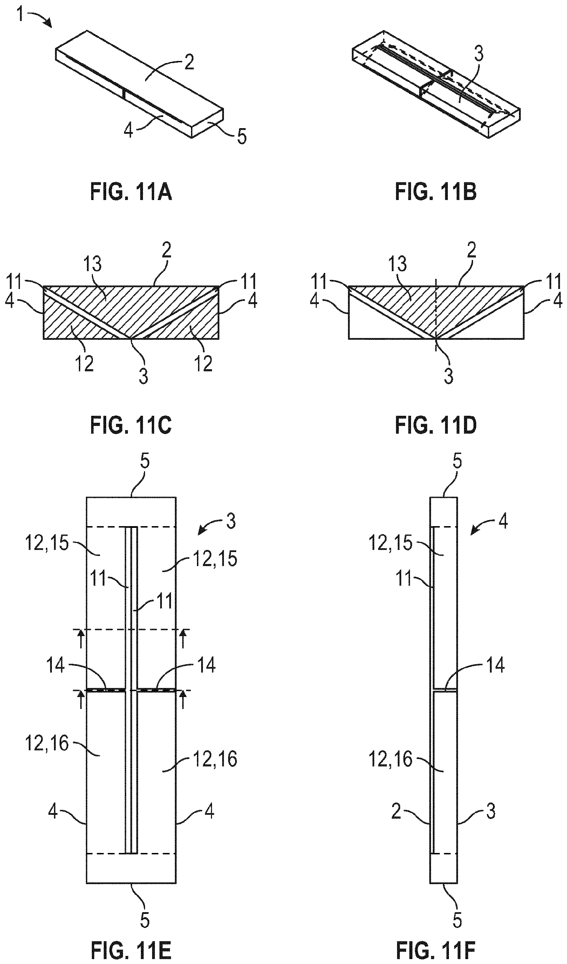

Figures 11A - 11F show yet a further embodiment of an evaporation boat according to the present disclosure with a rectangular cross-sectional area. Dimensions may be 10 x 30 x 130 mm, for example. Figure 11A is a 3D view of the upper side, Figure 11B is a 3D view of the underside. Both lateral surfaces 4 of the evaporation boat each have a first slit 11 in a direction along the lateral surface which is not extending to the clamping surfaces 5. This first slit 11 is directed to the underside 3 of the evaporation boat (see Figures 11A-11E), thereby creating a lower lateral region 12 of the evaporation boat which is partially separated from an upper region 13 of the evaporation boat. The two lateral surfaces having each a first slit each have furthermore a second slit 14 in a direction perpendicular to the first slit 11, dividing the lower lateral region 12 of the evaporation boat into two parts 15, 16. The lower lateral region 12 has a reduced current flow compared to the upper region of the evaporation boat. Figure 11E is a plan view of the underside, Figure 11F is a plan view of one of the lateral surfaces. The other lateral surface is identical to Figure 11F. Figure 11C is a cross sectional view of the evaporation boat at a position which is indicated in Figure 11E by the upper arrows. The cross-sectional area at this position has a rectangular shape, with the first slit 11 at the lateral surface 4 directed to the underside 3. Figure 11D is a cross sectional view of the evaporation boat at the position of the two slits 14 which is indicated in Figure 11E by the lower arrows. The cross-sectional area at this position has a trapezoidal shape. The smaller side of the two parallel sides of the trapezoid has a length of 2 mm. The first slit 11 of each lateral surface 4 which is directed to the underside of the evaporation boat is extending to the underside of the evaporation boat (see Figures 11A - 11E), which means that the underside 3 has two slits 11 in a direction along the lateral surface which are not extending to the clamping surfaces (see Figure 11 E). The second slit 14 of each lateral surface is also extending to the underside of the evaporation boat (Figures 11E, 11F). The width of the slits is 1 mm. At a region having a length of 10 mm at both ends of the evaporation boat, there may be no slits, as these two regions are the clamping regions of the evaporation boat. The first slits 11, which are in a direction along the lateral surfaces and are extending from the lateral surfaces to the underside of the evaporation boat, are not extending to the upper side of the evaporation boat, thereby avoiding that liquid metal flows into the slits. If liquid metal would flow into the slits, the lower lateral region 12 of the evaporation boat which is partially separated from an upper region 13 of the evaporation boat by the slits 11 would no longer be partially separated from the upper region, and the lower lateral region would not have a reduced current flow compared to the upper region. By the slits 11, 14 of the evaporation boat of this embodiment, heat losses at both lateral surfaces and at the underside of the evaporation boat are reduced compared to an evaporation boat with a rectangular cross-sectional area and without slits. With this embodiment, the temperature of the radiating surface area can be reduced compared to a standard evaporation boat with a rectangular cross-sectional area and without recesses. The upper region 13 of the evaporation boat has a higher current flow than the lower lateral regions 12. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

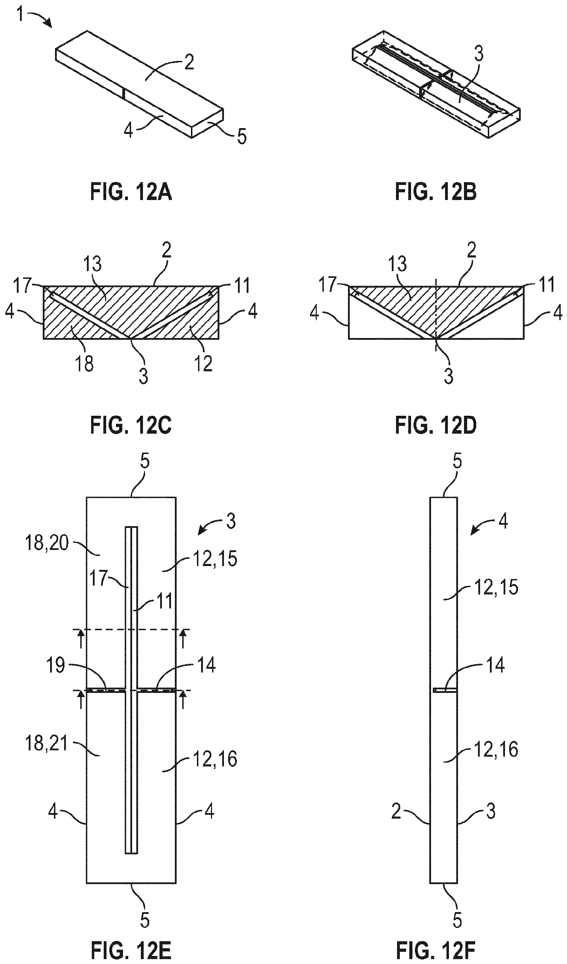

Figures 12A - 12F show yet a further embodiment of an evaporation boat 1 according to the present disclosure with a rectangular cross-sectional area. Dimensions may be 10 x 30 x 130 mm, for example. Figure 12A is a 3D view of the upper side 2, Figure 12B is a 3D view of the underside 3. The underside of the evaporation boat has a first slit 11 in a direction along the underside 3 which is not extending to the clamping surfaces 5, and this first slit 11 is directed to one of the lateral surfaces 4 of the evaporation boat, thereby creating a first lower region 12 of the evaporation boat which is partially separated from an upper region 13 of the evaporation boat. The lateral surface of the evaporation boat to which the first slit is directed to has a second slit 14 in a direction perpendicular to the first slit, dividing the first lower region of the evaporation boat into two parts 15, 16. The underside of the evaporation boat has a third slit 17 in a direction along the underside 3 which is not extending to the clamping surfaces 5, and this third slit 17 is directed to the other lateral surface of the evaporation boat, thereby creating a second lower region 18 of the evaporation boat which is partially separated from an upper region 13 of the evaporation boat. The lateral surface of the evaporation boat to which the third slit 17 is directed to has a fourth slit 19 in a direction perpendicular to the third slit 17, dividing the second lower region of the evaporation boat into two parts 20, 21. The first and second lower lateral region 12, 18 have a reduced current flow compared to the upper region 13 of the evaporation boat. Figure 12E is a plan view of the underside, Figure 12F is a plan view of one of the lateral surfaces, having the second slit 14. The other lateral surface having the fourth slit 19 is mirror-inverted to Figure 12F. Figure 12C is a cross sectional view of the evaporation boat at a position which is indicated in Figure 12E by the upper arrows. The cross-sectional area at this position has a rectangular shape, with the first slit 11 at the underside 3 directed to one of the lateral surfaces 4, and with the third slit 17 at the underside 3 directed to the other lateral surface 4. Figure 12D is a cross sectional view of the evaporation boat at the position of the slits 14, 19 which is indicated in Figure 12E by the lower arrows. The cross section at this position has a trapezoidal shape. The smaller side of the two parallel sides of the trapezoid has a length of 2 mm. As can be seen in Figures 12A, 12C, 12D and 12F, the first slit 11 in a direction along the underside 3 which is directed to one of the lateral surfaces 4 of the evaporation boat does not extend to this lateral surface, and also the third slit 17 in a direction along the underside 3 which is directed to the other lateral surface 4 of the evaporation boat does not extend to this lateral surface. The second slit 14 of one lateral surface and the fourth slit 19 of the other lateral surface are extending to the underside of the evaporation boat (Figure 12E). The width of the slits is 1 mm. At a region having a length of 10 mm at both ends of the evaporation boat, there may be no slits, as these two regions are the clamping regions of the evaporation boat. The first and third slit 11, 17, which are in a direction along the underside 3 and are not extending to the lateral surfaces 4, are also not extending to the upper side of the evaporation boat, thereby avoiding that liquid metal flows into the slits. If liquid metal would flow into the slits, the lower lateral regions 12, 18 of the evaporation boat which are partially separated from an upper region 13 of the evaporation boat by the slits 11, 17 would no longer be partially separated from the upper region 13, and the lower lateral regions 12, 18 would not have a reduced current flow compared to the upper region 13. By the slits 11, 14, 17, 19 of the evaporation boat of this embodiment, heat losses at both lateral surfaces 4 and at the underside 3 of the evaporation boat are reduced compared to an evaporation boat with a rectangular cross-sectional area and without slits or recesses. With this embodiment, the temperature of the radiating surface area can be reduced compared to a standard evaporation boat with a rectangular cross-sectional area and without recesses. The upper region 13 of the evaporation boat has a higher current flow than the lower lateral regions 12, 18. Therefore the temperature of the lateral surfaces 4 and of the underside 3 is lower compared to a standard evaporation boat with rectangular cross-sectional area and without recesses or slits, and as a consequence the power radiated from the lateral surfaces 4 and of the underside 3 is also lower.

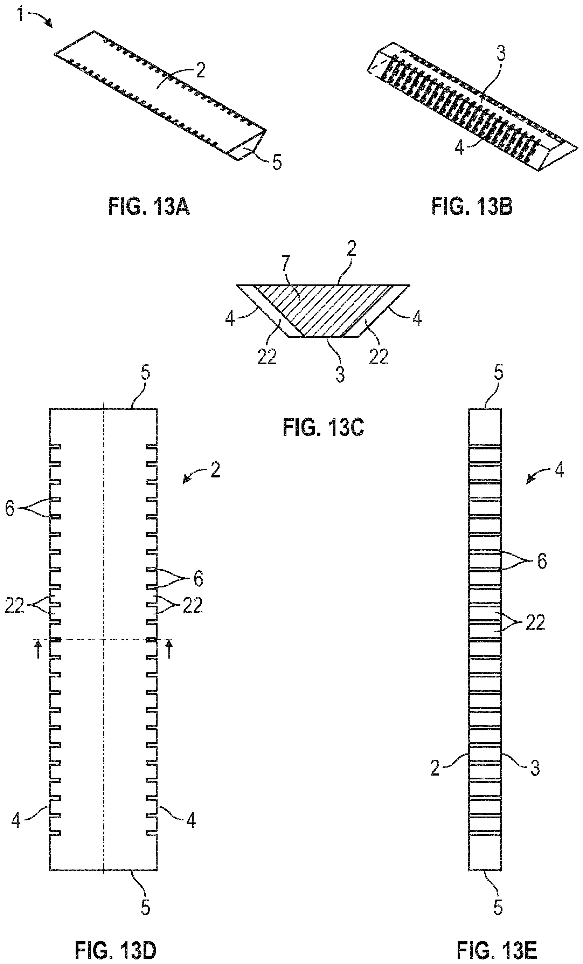

Figures 13A - 13E show an embodiment of an evaporation boat 1 according to the present disclosure with a trapezoidal cross-sectional area. The evaporation boat may have a length of 130 mm and a height of 10 mm, the upper side 2 may have a breadth of 30 mm and the underside 3 may have a breadth of 10 mm, for example. Figure 13A is a 3D view of the upper side 2, Figure 13B is a 3D view of the underside 3. The lateral surfaces 4 have an angle of 45° with the upper side 2 of the evaporation boat. Both lateral surfaces of the evaporation boat each have 23 slits. The 23 slits have a direction parallel to the clamping surfaces 5 and perpendicular to the lateral surfaces 4. Figure 13D is a plan view of the upper side 2, Figure 13E is a plan view of one of the lateral surfaces 4. The other lateral surface is identical to Figure 13E. Figure 13C is a cross sectional view of the evaporation boat at the position of one of the slits which is indicated in Figure 13D by arrows. The cross section at this position has a trapezoidal shape with a reduced cross sectional area, whereas the cross section at the positions between the slits and in the clamping area near the clamping surfaces 5 has a larger cross sectional area (see Figure 13C). The 23 slits are extending from the lateral surface 4 to the underside 3 of the evaporation boat. As can be seen from Figure 13D representing a plan view of the upper side 2, the slits 6 of both lateral surfaces 4 are extending to the upper side 2 of the evaporation boat, to a kind of lateral stripe having a breadth of 2 mm. The slits of both lateral surfaces 4 are extending also to the underside 3 of the evaporation boat (Figures 13B, 13C). The width of the slits is 1 mm. The distance between each two of the slits is 5 mm. At a region having a length of 10 mm at both ends of the evaporation boat, there may be no slits, as these two regions are the clamping regions of the evaporation boat. By the slits of the evaporation boat of this embodiment, heat losses at both lateral surfaces and at the underside of the evaporation boat are reduced compared to an evaporation boat with a trapezoidal cross section and without slits, and also compared to an evaporation boat with a rectangular cross-sectional area and without slits. With this embodiment, the temperature of the radiating surface area can be reduced compared to a trapezoidal evaporation boat without recesses. The core region 7 of the evaporation boat (see Figure 13C), which is composed of the regions having a reduced trapezoidal cross-sectional area at the positions of the 23 slits and the regions with this reduced trapezoidal cross-sectional area between the positions of the 23 slits, has a higher current flow than the regions 22 between the 23 slits (see Figures 13C, 13D, 13E). Therefore the temperature of the lateral surfaces 4 and of the underside 3 is lower compared to a standard evaporation boat with rectangular cross-sectional area and without recesses or slits, and also compared to an evaporation boat with a trapezoidal cross-sectional area and without recesses or slits, and as a consequence the power radiated from the lateral surfaces and of the underside is also lower.

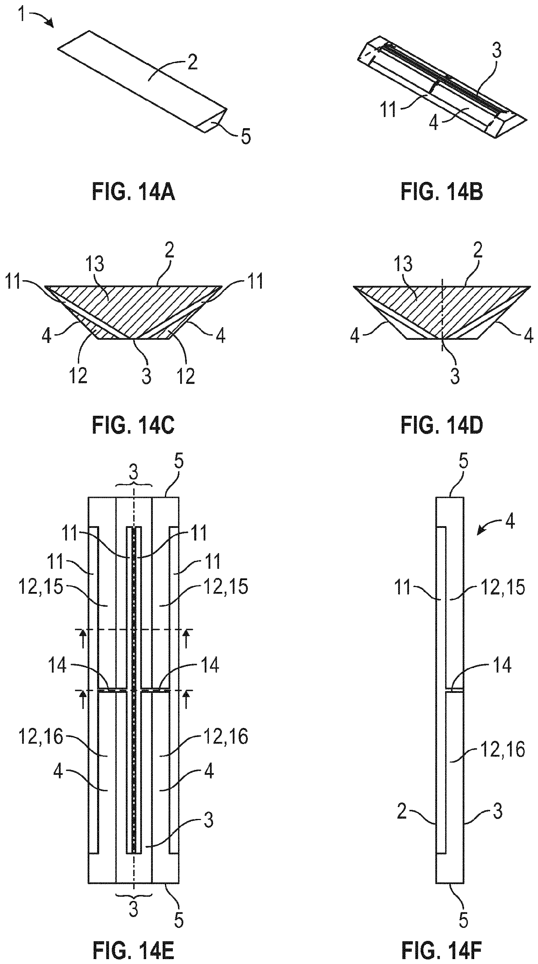

Figures 14A - 14F show a further embodiment of an evaporation boat 1 according to the present disclosure with a trapezoidal cross sectional area. The evaporation boat may have a length of 130 mm and a height of 10 mm, the upper side 2 may have a breadth of 30 mm and the underside 3 may have a breadth of 10 mm, for example. Figure 14A is a 3D view of the upper side 2, Figure 14B is a 3D view of the underside 3. The lateral surfaces 4 have an angle of 45° with the upper side 2 of the evaporation boat. Both lateral surfaces of the evaporation boat each have a first slit 11 in a direction along the lateral surface which is not extending to the clamping surfaces 5. This first slit 11 is directed to the underside 3 of the evaporation boat (see Figures 14C, 14D, 14E), thereby creating a lower lateral region 12 of the evaporation boat which is partially separated from an upper region 13 of the evaporation boat. The two lateral surfaces 4 having each a first slit 11 each have furthermore a second slit 14 in a direction perpendicular to the first slit 11, dividing the lower lateral region 12 of the evaporation boat into two parts 15, 16. The lower lateral region 12 has a reduced current flow compared to the upper region of the evaporation boat. Figure 14E is a plan view of the underside, Figure 14F is a plan view of one of the lateral surfaces 4. The other lateral surface is identical to Figure 14F. Figure 14C is a cross sectional view of the evaporation boat at a position which is indicated in Figure 14E by the upper arrows. The cross-sectional area at this position has a trapezoidal shape, with the first slits 11 at the lateral surfaces 4 directed to the underside 3. Figure 14D is a cross sectional view of the evaporation boat at the position of the two slits 14 which is indicated in Figure 14E by the lower arrows. The cross-sectional area at this position has a trapezoidal shape. The smaller side of the two parallel sides of the trapezoid has a length of 2 mm. The first slit 11 of each lateral surface 4 which is directed to the underside of the evaporation boat is extending to the underside of the evaporation boat (see Figures 14A - 14E), which means that the underside 3 has two slits 11 in a direction along the lateral surface which are not extending to the clamping surfaces (see Figure 14E). The second slit 14 of each lateral surface is also extending to the underside 3 of the evaporation boat (Figures 14E, 14F). The width of the slits is 1 mm. At a region having a length of 10 mm at both ends of the evaporation boat, there may be no slits, as these two regions are the clamping regions of the evaporation boat. The first slits 11, which are in a direction along the lateral surfaces and are extending from the lateral surfaces to the underside of the evaporation boat, are not extending to the upper side 2 of the evaporation boat, thereby avoiding that liquid metal flows into the slits. If liquid metal would flow into the slits, the lower lateral region 12 of the evaporation boat which is partially separated from an upper region 13 of the evaporation boat by the slits 11 would no longer be partially separated from the upper region, and the lower lateral region would not have a reduced current flow compared to the upper region. By the slits 11, 14 of the evaporation boat of this embodiment, heat losses at both lateral surfaces and at the underside of the evaporation boat are reduced compared to an evaporation boat with a rectangular cross-sectional area and without slits, and also compared to an evaporation boat with a trapezoidal cross-sectional area and without slits. With this embodiment, the temperature of the radiating surface area can be reduced compared to a standard evaporation boat with a rectangular cross-sectional area and without recesses, and also compared to an evaporation boat with a trapezoidal cross-sectional area and without slits. The upper region 13 of the evaporation boat has a higher current flow than the lower lateral regions 12. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

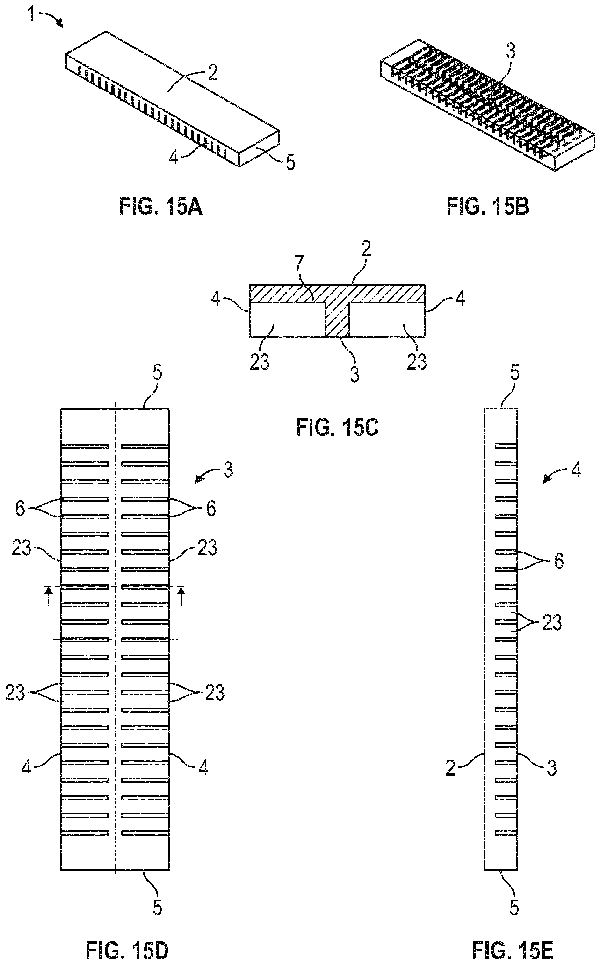

Figures 15A - 15E show yet a further embodiment of an evaporation boat according to the present disclosure with a rectangular cross-sectional area. Dimensions may be 10 x 30 x 130 mm, for example. Figure 15A is a 3D view of the upper side 2, Figure 15B is a 3D view of the underside 3. Both lateral surfaces 4 of the evaporation boat have 23 slits 6. The 23 slits have a direction parallel to the clamping surfaces 5 and perpendicular to the lateral surfaces 4. Figure 15D is a plan view of the underside 3, Figure 15E is a plan view of one of the lateral surfaces 4. The other lateral surface is identical to Figure 15E. Figure 15C is a cross sectional view of the evaporation boat at the position of one of the slits which is indicated in Figure 15D by arrows. The cross section at this position has a shape in T-form (see Figure 15C), whereas the cross section at the positions between the slits and in the clamping area near the clamping surfaces is rectangular. The 23 slits 6 are extending from the lateral surface 4 to the underside 3 of the evaporation boat. The cross-sectional shape of the slits is the form of a rectangle. As can be seen from Figure 15D representing a plan view of the underside 3, the slits 6 of both lateral surfaces 4 are extending to almost half of the underside. As can be seen from Figure 15E representing a plan view of a lateral surface 4, the slits 6 at the lateral side are not extending to the upper side of the evaporation boat. There are no slits at the upper side of the evaporation boat (see Figure 15A), the plan view of the upper side 2 corresponds to Figure 1C. The width of the slits is 1 mm. The distance between each two of the slits is 5 mm. At a region having a length of 10 mm at both ends of the evaporation boat, there may be no slits, as these two regions are the clamping regions of the evaporation boat. By the slits of the evaporation boat of this embodiment, heat losses at both lateral surfaces and at the underside of the evaporation boat are reduced compared to an evaporation boat with a rectangular cross-sectional area and without slits. With this embodiment, the temperature of the radiating surface area can be reduced compared to a standard evaporation boat without recesses. The core region 7 of the evaporation boat (see Figure 15C), which is composed of the regions having a cross-sectional area shaped in T-form at the positions of the 23 slits 6 and the regions having this cross-sectional area shaped in T-form between the positions of the 23 slits 6, has a higher current flow than the regions 23 between the 23 slits 6 having a rectangular cross-sectional area. Therefore the temperature of the lateral surfaces 4 and of the underside 3 is lower compared to a standard evaporation boat with rectangular cross-sectional area and without recesses or slits, and as a consequence the power radiated from the lateral surfaces and of the underside is also lower.

The slits of the embodiments shown in Figures 2A - 2E to 15A - 15E may also be coated or filled at least partially with an inorganic material. With the slits being coated or filled with an inorganic material, the temperature and the emissivity of the radiating surface area may be reduced compared to an evaporation boat without recesses and without a coating with an inorganic material. Additionally to the slits being coated or filled with an inorganic material, at least one of the lateral surfaces and/or the underside of the embodiments shown in Figures 2A - 2E to 15A - 15E may be coated at least partially with an inorganic material. The inorganic material may comprise oxides such as aluminum oxide or its precursors from a sol-gel process, hydroxides such as aluminum hydroxide, borides such as titanium diboride, tungsten borides and molybdenum boride, carbides, nitrides such as boron nitride, aluminum nitride and titanium nitride, minerals, metals, high melting glasses or combinations thereof.

The evaporation boat as disclosed herein is used for evaporating metals selected from the group consisting of aluminum, copper and silver. In some embodiments of the present disclosure, the evaporation boat is used for evaporating aluminum for transparent aluminum oxide ($AlO_x$) coatings.

Examples

Examples 1 - 4 and Comparative Example 1

Evaporation boats according to the present disclosure as shown in Figures 2A - 2E (Example 1), 5A - 5E (Example 2), 7A - 7E (Example 3) and 11A - 11 F (Example 4) were prepared and tested in a lab coater under the typical conditions of a standard web coating process.

For comparison, a standard evaporation boat having a rectangular cross-sectional area according to Figures 1A - 1D was also tested (Comparative Example 1). The dimensions of all tested evaporation boats were 10 x 30 x 130 mm. All evaporation boats were produced from one lot from a powder mixture comprising titanium diboride and boron nitride, with a titanium diboride content of 48.5 wt.-%.

The results achieved in terms of power savings with reference to the standard evaporation boat with rectangular cross-sectional area are shown in table 1.

Table 1:

| Al feeding rate [g/cm$^2$ * min] | Comparative Example 1 | Example 1 | Example 2 | Example 3 | Example 4 |
| --- | --- | --- | --- | --- | --- |
| 0.21 | 0% (reference) | $\geq$ 20% | $\geq$ 15% | $\geq$ 15% | $\geq$ 25% |
| 0.25 | 0% (reference) | $\geq$ 20% | $\geq$ 15% | $\geq$ 15% | $\geq$ 25% |
| 0.29 | 0% (reference) | $\geq$ 20% | $\geq$ 15% | $\geq$ 15% | $\geq$ 25% |

Aluminum feeding rate is the amount of aluminum which is fed to the boat in one minute and per cm$^2$ of usable area on the upper side of the boat. For Examples 1 - 4, the calculation of the aluminum feeding rate is based on a usable area of size 28 x 110 mm.

Example 5 and Comparative Example 2

An evaporation boat according to the present disclosure as shown in Figures 9A - 9E was prepared and tested in a lab coater under the typical conditions of a standard web coating process (Example 5).

For comparison, a standard evaporation boat having a rectangular cross-sectional area according to Figures 1A - 1D was also tested (Comparative Example 2). The dimensions of all tested evaporation boats were 10 x 30 x 130 mm Aluminum feeding rate was calculated as explained for Examples 1 - 4 and was up to 0.37 g/cm$^2$ * min.

All evaporation boats were produced from one lot from a powder mixture comprising titanium diboride and boron nitride, with a titanium diboride content of 48.7 wt.-%.

The area of the upper side of the evaporation boat which was wetted by aluminum was significantly larger for the evaporation boat according to Figures 9A - 9E than for the evaporation boat having a rectangular cross-sectional area, specifically in longitudinal direction towards the clamping system. As a result of that, a higher aluminum feeding rate of up to 0.37 g/cm$^2$ *min was possible. This can be explained as the regions having reduced cross-sectional areas, i.e. the regions with the slits covering the first and the last third of the total length of the evaporation boat, will have higher temperatures on the upper side where the metal is evaporated compared to a standard evaporation boat without slits.

Examples 6 - 7 and Comparative Example 3

An evaporation boat according to the present disclosure as shown in Figures 2A - 2E was prepared and tested in an industrial vacuum web coater (Example 6).

A further test was carried out in an industrial vacuum web coater with an evaporation boat according to the present disclosure as shown in Figures 2A - 2E and with the slits being filled with a mixture of boron nitride and aluminum oxide (Example 7). The boron nitride content of the mixture of boron nitride and aluminum oxide was 85 wt.-%. The mixture was acting both as thermally insulating material and as inorganic material reducing the emissivity. The mixture was provided as paste to easily fill the slits, with subsequent drying to remove the liquid carrier. The final porous structure of the boron nitride/aluminum oxide mixture had a density of 50% of the theoretical density.

For comparison, a standard evaporation boat having a rectangular cross-sectional area according to Figures 1A - 1D was also tested (Comparative Example 3).

The dimensions of all tested evaporation boats were 10 x 30 x 150 mm. Aluminum feeding rate was calculated as explained for Examples 1 - 4, based on a usable area of size 28 x 130 mm, and was up to 0.25 g/cm$^2$ * min.

The boat having a rectangular cross section had a cavity on the upper side with the dimension 1 x 28 x 130 mm, Examples 6 and 7 had no cavity.

All evaporation boats were produced from one lot from a powder mixture comprising titanium diboride and boron nitride, with a titanium diboride content of 47.1 wt.-%.

Compared to the evaporation boat with the rectangular cross-sectional area of Comparative Example 3, the evaporation boat according to Example 6 had a lower temperature of the radiating surfaces for the same aluminum feeding rates. The evaporation boat according to Example 7 also had a lower temperature of the radiating surfaces compared to the evaporation boat with the rectangular cross-sectional area. Compared to Example 6, the evaporation boat of Example 7 in addition showed an improvement to wet out the aluminum over the upper side of the boat, especially at aluminum feeding rates above 0.20 g/cm$^2$ * min.

Example 8 and Comparative Example 4

An evaporation boat according to Figs. 1A - 1D was coated on the radiating surfaces with a thin layer of boron nitride. The thickness of the layer was approx. 100 $\mu$m.

Test conditions in the lab coater were the same typical conditions of a standard web coating process.

For comparison, a standard evaporation boat having a rectangular cross-sectional area according to Figs. 1A - 1D without coating was also tested (Comparative Example 4). The dimensions of all tested evaporation boats were 10 x 30 x 130 mm. Aluminum feeding rate was calculated as explained for Examples 1 - 4, based on a usable area of size 28 x 110 mm, and was up to 0.35 g/cm$^2$ * min.

All evaporation boats were produced from one lot from a powder mixture comprising titanium diboride and boron nitride, with a titanium diboride content of 49.2 wt.-%.

The evaporation boat with boron nitride coating achieved up to 20% power savings compared to the boat without boron nitride coating.

**Claims**

1. Evaporation boat (1) for evaporation of metals, wherein the evaporation boat (1) has an upper side (2), an underside (3), two lateral surfaces (4) and two clamping surfaces (5), and wherein metal is evaporated from the upper side (2), and wherein the evaporation boat (1) has a means for reducing losses by heat radiation under operation of the evaporation boat, and wherein the means for reducing losses by heat radiation is selected from either one of the following or a combination thereof:

(a) at least one of the lateral surfaces (4) and/or the underside (3) of the evaporation boat (1) has at least one recess (6, 11, 14, 17, 19),

(b) at least one of the lateral surfaces (4) and/or the underside (3) of the evaporation boat (1) is coated at least partially with an inorganic material.

2. The evaporation boat (1) according to claim 1, wherein the underside (3) of the evaporation boat (1) has at least one recess (6, 11, 14, 17, 19), and wherein the at least one recess (6, 11, 14, 17, 19) of the underside (3) of the evaporation boat (1) is not extending to the upper side (2) of the evaporation boat, provided that the at least one recess (6, 11, 14, 17, 19) of the underside (3) of the evaporation boat (1) is not extending to the lateral surfaces (4).

3. The evaporation boat (1) according to claim 1 or 2, wherein at least one of the two lateral surfaces (4) and/or the underside (3) of the evaporation boat (1) has at least two, or at least three, or at least four recesses (6, 11, 14, 17, 19).

4. The evaporation boat (1) according to any of claims 1 to 3, wherein at least one of the two lateral surfaces (4) and/or the underside (3) of the evaporation boat (1) has at least one recess (6, 11, 14, 17, 19), and wherein the width of the at least one recess is at least 0.15 mm and at most 150 mm.

5. The evaporation boat (1) according to any of claims 1 to 4, wherein at least one of the two lateral surfaces (4) and/or the underside (3) of the evaporation boat (1) has at least two recesses (6), and wherein the distance between each two of the recesses (6) is at least 0.3 mm, and wherein the distance between each two of the recesses (6) is at most the length of the evaporation boat (1) minus 5 mm.

6. The evaporation boat (1) according to any of claims 1 to 5, wherein at least one of the two lateral surfaces (4) and the underside (3) of the evaporation boat (1) has one or more recesses (6, 11, 14, 17, 19), and wherein the one or more recesses (6, 11, 14, 17, 19) of the at least one of the two lateral surfaces (4) are extending to the underside (3) of the evaporation boat (1).

7. The evaporation boat (1) according to any of claims 1 to 6, wherein at least one of the lateral surfaces (4) and/or the underside (3) of the evaporation boat (1) has at least one recess (6), the evaporation boat (1) and the recesses (6) having each a cross-sectional area, wherein each recess (6) is covering a cross-sectional area of at least 5% of the cross-sectional area of the evaporation boat (1).

8. The evaporation boat (1) according to any of claims 1 to 7, wherein at least one of the lateral surfaces (4) and/or the underside (3) of the evaporation boat (1) has one or more recesses (6), and wherein the one or more recesses (6) have a direction parallel to the clamping surfaces (5) and perpendicular to the lateral surfaces (4), or wherein the one or more recesses (6) have a direction not parallel to the clamping surfaces (5) and has an angle of less than 90° to one of the clamping surfaces (5).

9. The evaporation boat (1) according to any of claims 1 to 3, wherein at least one of the lateral surfaces (4) of the evaporation boat (1) has a first recess (11) in a direction along the lateral surface (4) which is not extending to the clamping surfaces (5), and wherein this first recess (11) is directed to the underside (3) of the evaporation boat (1), thereby creating a lower lateral region (12) of the evaporation boat (1) which is partially separated from an upper region (13) of the evaporation boat (1), and wherein the at least one of the lateral surfaces (4) with the first recess (11) has a second recess (14) in a direction not parallel to the first recess (11), dividing the lower lateral region (12) of the evaporation boat (1) into two parts (15, 16).

10. The evaporation boat (1) according to any of claims 1 to 3, wherein the underside (3) of the evaporation boat (1) has a first recess (11) in a direction along the underside (3) which is not extending to the clamping surfaces (5), and wherein this first recess (11) is directed to one of the lateral surfaces (4) of the evaporation boat (1), thereby creating a first lower region (12) of the evaporation boat which is partially separated from an upper region (13) of the evaporation boat (1), and wherein the lateral surface (4) of the evaporation boat (1) to which the first recess (11) is directed to has a second recess (14) in a direction not parallel to the first recess (11), dividing the first lower region (12) of the evaporation boat into two parts (15, 16),

and wherein the underside (3) of the evaporation boat (1) optionally has a third recess (17) in a direction along the underside (3) which is not extending to the clamping surfaces (5), and wherein this third recess (17) is directed to the other lateral surface (4) of the evaporation boat (1), thereby creating a second lower region (18) of the evaporation boat (1) which is partially separated from an upper region (13) of the evaporation boat (1), and wherein the lateral surface (4) of the evaporation boat (1) to which the third recess (17) is directed to has a fourth recess (19) in a direction not parallel to the third recess (17), dividing the second lower region (18) of the evaporation boat (1) into two parts (20, 21).

11. The evaporation boat (1) according to any of claim 1 to 10, wherein at least one of the lateral surfaces (4) and/or the underside (3) of the evaporation boat (1) has at least one recess (6, 11, 14, 17, 19), wherein the lateral surfaces (4) and the underside (3) of the evaporation boat (1) each have a surface area, and wherein 0.1 to 65% of the total surface area of the lateral surfaces (4) and the underside (3) of the evaporation boat (1) has recesses (6, 11, 14, 17, 19).

12. The evaporation boat (1) according to any of claims 1 to 11, wherein the evaporation boat (1) has a cross-sectional area, and wherein the cross-sectional area is rectangular, triangular, trapezoidal, or shaped as segment of an ellipse or circle.

13. The evaporation boat (1) according to any of claims 1 to 12, wherein the material from which the evaporation boat (1) is made comprises titanium diboride and boron nitride.

14. The evaporation boat (1) according to any of claims 1 to 13, at least one of the lateral surfaces (4) and/or the underside (3) of the evaporation boat (1) having at least one recess (6, 11, 14, 17, 19), wherein the at least one recess is coated or filled with an inorganic material, or/and wherein at least one of the lateral surfaces (4) and/or the underside (3) of the evaporation boat (1) is coated with an inorganic material.

15. Use of the evaporation boat (1) according to any of claims 1 to 14 for evaporating metals selected from the group consisting of aluminum, copper and silver.

FIG. 1A

FIG. 1B

FIG. 1C

FIG. 1D

FIG. 2A

FIG. 2B

FIG. 2C

FIG. 2D

FIG. 2E

FIG. 3A

FIG. 3B

FIG. 3C

FIG. 3D

FIG. 3E

FIG. 4A

FIG. 4B

FIG. 4C

FIG. 4D

FIG. 4E

FIG. 5A

FIG. 5B

FIG. 5C

FIG. 5D

FIG. 5E

FIG. 6A

FIG. 6B

FIG. 6C

FIG. 6D

FIG. 6E

FIG. 7A

FIG. 7B

FIG. 7C

FIG. 7D

FIG. 7E

FIG. 8A

FIG. 8B

FIG. 8C

FIG. 8D

FIG. 8E

FIG. 9A

FIG. 9B

FIG. 9C

FIG. 9D

FIG. 9E

FIG. 10A

FIG. 10B

FIG. 10C

FIG. 10D

FIG. 10E

FIG. 11A

FIG. 11B

FIG. 11C

FIG. 11D

FIG. 11E

FIG. 11F

FIG. 12A

FIG. 12B

FIG. 12C

FIG. 12D

FIG. 12E

FIG. 12F

**FIG. 13A**

**FIG. 13B**

**FIG. 13C**

**FIG. 13D**

**FIG. 13E**

**FIG. 14A**

**FIG. 14B**

**FIG. 14C**

**FIG. 14D**

**FIG. 14E**

**FIG. 14F**

FIG. 15A

FIG. 15B

FIG. 15C

FIG. 15D

FIG. 15E

Europäisches
Patentamt
European
Patent Office
Office européen
des brevets

## EUROPEAN SEARCH REPORT

**Application Number**

EP 17 19 5775

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2008/245305 A1 (IKARASHI KOUKI [JP] ET AL) 9 October 2008 (2008-10-09) <br> * page 1, paragraphs 5,6,11,12,21 - page 2, paragraphs 33,41,43; figures 1-3 * <br> * page 3, paragraphs 43,44,54 - page 4, paragraph 61 * | 1-5,7,8, 11-13,15 | INV. <br> C23C14/24 <br> C23C14/26 <br> F27D5/00 |
| X | US 2007/110412 A1 (RUSINKO DAVID M JR [US] ET AL) 17 May 2007 (2007-05-17) <br> * page 1, paragraphs 2,9 - page 2, paragraph 26; figures 1-12,15 * <br> * page 3, paragraphs 36,37,39 - page 4, paragraphs 48,49 * | 1-5, 12-15 | |
| X | JP H01 279749 A (FUJI ELECTRIC CO LTD) 10 November 1989 (1989-11-10) <br> * abstract; figure 1 * | 1,2 | |
| A | JP 2008 169458 A (DENKI KAGAKU KOGYO KK) 24 July 2008 (2008-07-24) <br> * the whole document * | 1-15 | |
| | | | **TECHNICAL FIELDS SEARCHED (IPC)** <br><br> C23C <br> F27D |

The present search report has been drawn up for all claims

| Place of search | Date of completion of the search | Examiner |
|---|---|---|
| The Hague | 12 April 2018 | Boussard, Nadège |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 17 19 5775

This annex lists the patent family members relating to the patent documents cited in  the above-mentioned European search report.
The members are as contained in the European Patent Office EDP file on
The European Patent Office is in no way liable for these particulars which are merely given for the purpose of information.

12-04-2018

| Patent document cited in search report | | Publication date | Patent family member(s) | | | Publication date |
|---|---|---|---|---|---|---|
| US 2008245305 | A1 | 09-10-2008 | BR | PI0416831 | A | 13-02-2007 |
| | | | EP | 1688514 | A1 | 09-08-2006 |
| | | | JP | 4425860 | B2 | 03-03-2010 |
| | | | JP | WO2005049881 | A1 | 07-06-2007 |
| | | | KR | 20070017956 | A | 13-02-2007 |
| | | | US | 2008245305 | A1 | 09-10-2008 |
| | | | WO | 2005049881 | A1 | 02-06-2005 |
| US 2007110412 | A1 | 17-05-2007 | CN | 1958836 | A | 09-05-2007 |
| | | | DE | 102005057220 | A1 | 06-06-2007 |
| | | | JP | 2007138276 | A | 07-06-2007 |
| | | | KR | 20070048562 | A | 09-05-2007 |
| | | | US | 2007110412 | A1 | 17-05-2007 |
| JP H01279749 | A | 10-11-1989 | NONE | | | |
| JP 2008169458 | A | 24-07-2008 | JP | 4772705 | B2 | 14-09-2011 |
| | | | JP | 2008169458 | A | 24-07-2008 |

EPO FORM P0459

For more details about this annex : see Official Journal of the European Patent Office, No. 12/82

**EP 3 470 545 A1**

**Patent documents cited in the description**

- DE 19708599 C1
- DE 20309444 U1
- DE 20300167 U1
- WO 2004063419 A1
- US 6085025 A
- US 20160208373 A1
- US 20160208374 A1